(19) **Europäisches Patentamt / European Patent Office / Office européen des brevets**

(11) **EP 3 432 339 B1**

(12) **EUROPEAN PATENT SPECIFICATION**

(45) Date of publication and mention
of the grant of the patent:
**19.02.2020  Bulletin 2020/08**

(51) Int Cl.:
***H01J 37/20*** *(2006.01)*     ***H01J 37/22*** *(2006.01)*

(21) Application number: **18183182.7**

(22) Date of filing: **12.07.2018**

(54) **SURFACE ANALYSIS DEVICE AND SPECIMEN HEIGHT ADJUSTMENT METHOD**

OBERFLÄCHENANALYSEVORRICHTUNG UND PROBEHÖHENANPASSUNGSVERFAHREN

DISPOSITIF D'ANALYSE DE SURFACE ET PROCÉDÉ DE RÉGLAGE DE LA HAUTEUR DE SPÉCIMENS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.07.2017   JP 2017139266**

(43) Date of publication of application:
**23.01.2019   Bulletin 2019/04**

(73) Proprietor: **Jeol Ltd.**
**Akishima, Tokyo 196-8558 (JP)**

(72) Inventors:
 • **UCHIDA, Tatsuya**
   **Akishima, Tokyo 196-8558 (JP)**
 • **TSUTSUMI, Kenichi**
   **Akishima, Tokyo 196-8558 (JP)**
 • **SHIMAMURA, Daisuke**
   **Akishima, Tokyo 196-8558 (JP)**
 • **YOKOUCHI, Kazushiro**
   **Akishima, Tokyo 196-8558 (JP)**

(74) Representative: **Boult Wade Tennant LLP**
**Salisbury Square House**
**8 Salisbury Square**
**London EC4Y 8AP (GB)**

(56) References cited:
 **JP-A- H10 269 979      US-A1- 2013 068 949**
 **US-A1- 2013 112 871    US-B2- 9 552 641**

 • **KOSTER A J ET AL: "Automated microscopy for electron tomography", ULTRAMICROSCOPY, ELSEVIER, AMSTERDAM, NL, vol. 46, no. 1-4, 1 October 1992 (1992-10-01), pages 207-227, XP025826783, ISSN: 0304-3991, DOI: 10.1016/0304-3991(92)90016-D [retrieved on 1992-10-01]**
 • **WOLF D ET AL: "Towards automated electron holographic tomography for 3D mapping of electrostatic potentials", ULTRAMICROSCOPY, ELSEVIER, AMSTERDAM, NL, vol. 110, no. 5, 1 April 2010 (2010-04-01) , pages 390-399, XP027027870, ISSN: 0304-3991 [retrieved on 2010-01-13]**

**Description**

BACKGROUND OF THE INVENTION

The present invention relates to a surface analysis device and a specimen height adjustment method.

A eucentric specimen stage is employed in a surface analysis device such as an Auger electron microscope (AES), a scanning electron microscope (SEM), or an X-ray photoelectron spectroscope (XPS). By employing a eucentric specimen stage, a viewing field (an image center) can be prevented from moving even when a specimen is tilted.

When a eucentric specimen stage is employed in a surface analysis device, a height of the specimen must be adjusted to ensure that a specimen surface is positioned in a eucentric position. A eucentric position is a position of a tilt axis when the specimen is tilted, for example. JP-A-H10-269979 discloses a surface analysis device having a height adjustment mechanism that is capable of adjusting the height of a specimen automatically.

The surface analysis device is configured such that an axis of an electron beam optical system for irradiating the specimen surface with an electron beam, an axis of an ion beam optical system for irradiating the specimen surface with an ion beam, and an axis of a hemispherical electrostatic analyzer gather at a single point (an analysis point). In this surface analysis device, the analysis point can be aligned with the eucentric position.

In a surface analysis device having a eucentric specimen stage, such as that described above, the height of the specimen must be adjusted every time the specimen is replaced. Therefore, demand exists for a surface analysis device with which the height of a specimen can be adjusted easily and accurately.

SUMMARY

The invention can provide a surface analysis device and a specimen height adjustment method with which the height of a specimen can be adjusted easily and accurately.

According to a first aspect of the invention, there is provided a surface analysis device including a specimen stage having a height direction moving mechanism for moving a specimen in a direction of an optical axis of the surface analysis device and a tilting mechanism for tilting the specimen about a tilt axis,
the surface analysis device comprising a control section (or controlling the specimen stage,
the control section being configured to execute:

specimen image acquisition processing for obtaining a first specimen image captured with a first tilt angle of the specimen and a second specimen image captured with a second tilt angle of the specimen which is different from the first tilt angle;
deviation amount calculation processing for calculating an amount of deviation of a specimen surface from a reference height defined by the intersection between the tilt axis and the optical axis based on the first specimen image and the second specimen image; and
height control processing for controlling the specimen stage based on the amount of deviation of the specimen surface to align the height of the specimen surface at said intersection between the tilt axis and the optical axis,

characterized in that:

the control section is further configured to execute, in the deviation amount calculation processing,
generating a plurality of first partial images by cutting out a plurality of areas from the first specimen image,
generating a plurality of second partial images by cutting out a plurality of areas corresponding to the plurality of areas cut out from the first specimen image, from the second specimen image,
enlarging the plurality of first and second partial images to make them the same size as the first specimen image and the second specimen image, respectively,
calculating respective amounts of deviation of the cut-out areas from the reference height by measuring respective shift amounts between corresponding images of the first partial images and the second partial images
determining a median value from the amounts of deviation of the cut-out areas from the reference height, calculated from the respective areas, and
setting the median value as the amount of deviation of the specimen surface.

According to a second aspect of the invention, there is provided a specimen height adjustment method executed by a surface analysis device including a specimen stage that has a height direction moving mechanism for moving a specimen in a direction of an optical axis of the surface analysis device and a tilting mechanism for tilting the specimen about a tilt axis,
the method including:

obtaining a first specimen image captured with a first tilt angle of the specimen and a second specimen image captured with a second tilt angle of the specimen, which is different from the first tilt angle;

calculating an amount of deviation of a specimen surface from a reference height defined by the intersection between the tilt axis and the optical axis based on the first specimen image and the second specimen image; and

adjusting the height of the specimen based on the amount of deviation of the specimen surface to align the height of the specimen surface at said intersection between the tilt axis and the optical axis,

characterized in that:

in calculating the amount of deviation of the specimen surface,

a plurality of first partial images being generated by cutting out a plurality of areas from the first specimen image,

a plurality of second partial images being generated by cutting out a plurality of areas corresponding to the plurality of areas cut out from the first specimen image, from the second specimen image,

enlarging the plurality of first and second partial images to make them the same size as the first specimen image and the second specimen image, respectively,

calculating the amount of deviation of the cut-out areas from the reference height by measuring respective shift amounts between corresponding images of the first partial images and the second partial images,

determining a median value from the amounts of deviation of the cut-out areas from the reference height, calculated from the respective areas, and

setting the median value as the amount of deviation of the specimen surface.

## BRIEF DESCRIPTION OF THE SEVERAL VIEWS OF THE DRAWING

FIG. 1 is a diagram illustrating a configuration of a surface analysis device according to the first embodiment.

FIG. 2 illustrates specimen height adjustment.

FIG. 3 illustrates a method for determining an amount of deviation $\Delta Z$ of a specimen surface from a reference height.

FIG. 4 schematically illustrates two SEM images used during specimen height adjustment.

FIG. 5 illustrates a method for generating partial images from a SEM image $I_A$ having a tilt angle $T_0$.

FIG. 6 illustrates a method for generating partial images from a SEM image $I_B$ having a tilt angle $T_1$.

FIG. 7 is a flowchart illustrating an example of a flow of processing executed by a control section of the surface analysis device according to the first embodiment.

FIG. 8 is a flowchart illustrating an example of a flow of specimen height adjustment processing executed by the control section of the surface analysis device according to the first embodiment.

FIG. 9 is a flowchart illustrating an example of a flow of specimen height adjustment processing executed by a control section of a surface analysis device according to the second embodiment.

FIG. 10 is a flowchart illustrating an example of a flow of specimen height adjustment processing executed by a control section of a surface analysis device according to the third embodiment.

FIG. 11 illustrates a method for generating partial images from the SEM image $I_A$ having the tilt angle $T_0$.

FIG. 12 illustrates a method for generating partial images from the SEM image $I_A$ having the tilt angle $T_0$.

FIG. 13 illustrates a method for generating partial images from the SEM image $I_A$ having the tilt angle $T_0$.

FIG. 14 illustrates a method for generating partial images from the SEM image $I_A$ having the tilt angle $T_0$.

FIG. 15 is a schematic sectional view illustrating an example of a specimen.

FIG. 16 is a schematic sectional view illustrating an example of a specimen.

## DETAILED DESCRIPTION OF THE EMBODIMENT

According to one embodiment of the invention, there is provided a surface analysis device as defined in appended claim 1.

With this surface analysis device, the height of the specimen can be adjusted automatically, and therefore the height of the specimen can be adjusted easily. Further, the control section calculates the amount of deviation of the specimen surface by measuring, with respect to the plurality of first partial images and the plurality of second partial images, shift amounts between corresponding images of the first partial images and the second partial images, and therefore the amount of deviation of the specimen surface can be determined accurately. Hence, with this surface analysis device, the height of the specimen can be adjusted easily and accurately.

According to one embodiment of the invention, there is provided a specimen height adjustment method as defined in appended claim 9.

With this specimen height adjustment method, the height of the specimen can be adjusted easily and accurately.

Embodiments of the invention are described in detail below with reference to the drawings. Note that the following embodiments do not unduly limit the scope of the invention as stated in the claims. In addition, all of the elements described in connection with the following embodiments should not necessarily be taken as essential requirements of the invention.

1. First Embodiment

1.1. Surface Analysis Device

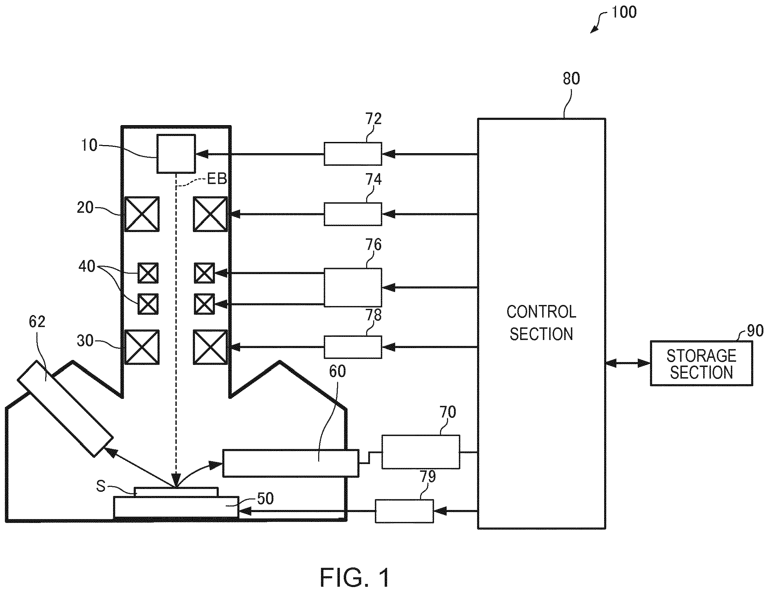

First, a surface analysis device according to the first embodiment will be described with reference to the figures. FIG. 1 is a diagram illustrating a configuration of a surface analysis device 100 according to the first embodiment. A case in which the surface analysis device 100 is an Auger electron microscope will be described below.

As illustrated in FIG. 1, the surface analysis device 100 includes an electron source 10, a condenser lens 20, an objective lens 30, a deflector 40, a specimen stage 50, a secondary electron detector 60, an electron spectroscope 62, a frame memory 70, driving devices 72, 74, 76, 78, 79, a control section 80, and a storage section 90.

The electron source 10 generates an electron beam EB. The electron source 10 is an electron gun, for example, that emits the electron beam EB by accelerating electrons emitted from a cathode using an anode.

The condenser lens 20 is a lens for forming an electron probe by condensing the electron beam EB emitted from the electron source 10. Using the condenser lens 20, a diameter and a probe current (an illumination current amount) of the electron prove can be controlled.

The objective lens 30 is a lens disposed directly in front of a specimen S in order to form an electron probe. An electron probe can be formed by condensing the electron beam EB emitted from the electron source 10 using the condenser lens 20 and the objective lens 30.

The deflector 40 deflects the electron beam EB (the electron probe) condensed by the condenser lens 20 and the objective lens 30. The deflector 40 is used to scan the specimen S using the electron probe, for example. More specifically, the deflector 40 deflects the electron probe two-dimensionally on the basis of a scanning signal from a scanning signal generation device (not shown). As a result, the specimen S can be scanned by the electron probe. The deflector 40 is also used to move the electron probe to a desired position of the specimen S and irradiate the desired position with the electron probe.

The specimen stage 50 holds the specimen S. The specimen stage 50 includes a horizontal direction moving mechanism for moving the specimen S in a horizontal direction, a height direction moving mechanism for moving the specimen S in a height direction, and a tilting mechanism for tilting the specimen S. The specimen stage 50 is a so-called eucentric stage, and is configured so that in a state where the height of the specimen S has been adjusted (in other words, a state where the surface of the specimen S is positioned in a eucentric position), a viewing field (an image center) does not move even when the specimen S is tilted.

The secondary electron detector 60 is a detector for detecting secondary electrons emitted from the specimen S when the specimen S is irradiated with the electron probe. The secondary electron detector 60 is configured to include a scintillator, a light guide, and a photomultiplier tube, for example. In the secondary electron detector 60, the secondary electrons are converted into light by the scintillator, the light is guided to the photomultiplier tube by the light guide, and the light is converted into an electric signal by the photomultiplier tube. An output signal (the electric signal) from the secondary electron detector 60 is transmitted to the frame memory 70.

The frame memory 70 stores a scanning electron microscope image (also referred to hereafter as an "SEM image"). The frame memory 70 stores the output signal (information indicating the intensity of the secondary electrons) from the secondary electron detector 60 in a storage area having an address that is specified on the basis of the scanning signal. As a result, a SEM image (a secondary-electron image) is stored in the frame memory 70.

The electron spectroscope 62 analyzes Auger electrons emitted from the specimen S in order to detect the analyzed Auger electrons. The electron spectroscope 62 uses a detector to detect electrons subjected to energy analysis by a hemispherical electrostatic analyzer, for example. An output signal from the detector is transmitted to a signal processing device (not shown), whereby a spectroscopic signal is generated. An Auger spectrum can be generated from the spectroscopic signal.

The control section 80 executes processing to control an optical system (the electron source 10, the condenser lens 20, the objective lens 30, and the deflector 40) of the surface analysis device 100, the specimen stage 50, the detectors (the secondary electron detector 60 and the electron spectroscope 62), and so on. For example, the control section 80 generates control signals corresponding to operations performed by a user, and transmits the control signals to the respective driving devices 72, 74, 76, 78, 79. As a result, the driving device 72 drives the electron source 10 on the basis of a control signal. Similarly, the driving device 74, the driving device 76, the driving device 78, and the driving device 79 operate the condenser lens 20, the deflector 40, the objective lens 30, and the specimen stage 50, respectively, on the basis of respective control signals. The control section 80 also executes processing for adjusting the height of the specimen. The processing for adjusting the height of the specimen will be described below. Functions of the control section 80 can be realized by executing a program stored in the storage section 90 using various processors (a CPU or the like).

The storage section 90 stores programs, data, and so on used by the control section 80 to execute various types of calculation processing. The storage section 90 is also used as a working area of the control section 80, and also used to temporarily store results of calculations executed by the control section 80 in accordance with various programs, and so on. Functions of the storage section 90 can be realized by a hard disk, a RAM, or the like.

Although not shown in the figures, the surface analysis device 100 further includes an ion gun, an optical system for irradiating the specimen S with ion beams emitted from the ion gun, and so on, and is thus capable of performing ion etching on the specimen S.

In the surface analysis device 100, mechanical eucentric adjustment is executed on the respective constituent members. In other words, the surface analysis device 100 is configured such that an axis of an optical system for irradiating the specimen surface with the electron beam EB, an axis of an optical system for irradiating the specimen surface with an ion beam, and an axis of the electron spectroscope 62 (an axis of the hemispherical electrostatic analyzer) gather at a single point (an analysis point). In the surface analysis device 100, the respective constituent parts of the surface analysis device 100 are adjusted so that the analysis point is aligned with (coincides with) the eucentric position.

1.2. Specimen Height Adjustment Method

Next, a specimen height adjustment method according to the first embodiment will be described.

(1) Principles

First, principles of the specimen height adjustment according to the first embodiment will be described.

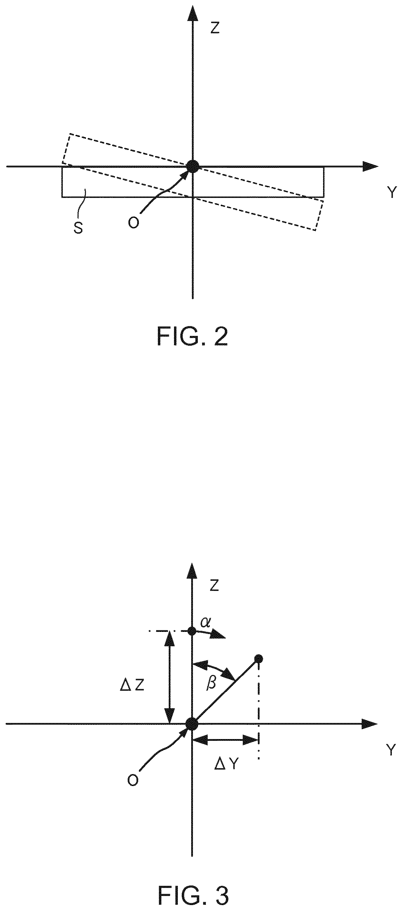

FIG. 2 illustrates specimen height adjustment. Note that FIG. 2 illustrates a Y axis and a Z axis as mutually orthogonal axes. Note that the Z axis is aligned with the optical axis of the optical system (the objective lens 30, for example).

Specimen height adjustment means adjusting the surface of the analysis subject specimen S (also referred to simply as the "specimen surface" hereafter) to a reference height (i.e. aligning the surface with the reference height). The reference height is a position of a tilt center O when the specimen S is tilted. When the specimen stage 50 tilts (rotates) the specimen S about the tilt axis, the tilt center O is an intersection between the tilt axis and the optical axis (the Z axis). Once the height of the specimen has been adjusted (in other words, once the height of the specimen surface has been aligned with the position of the tilt center O), the center of the SEM image does not move even when the specimen S is tilted (in other words, the viewing field does not move before and after tilting).

In the surface analysis device 100, the device is adjusted in advance so that the optical system, the secondary electron detector 60, and the electron spectroscope 62 are aligned with the position of the tilt center O. In other words, in the surface analysis device 100, mechanical eucentric adjustment is implemented. In the surface analysis device 100, the position of the tilt center O (the intersection between the tilt axis and the optical axis (the Z axis)) is adjusted so as to be positioned in the center of the SEM image.

Specimen height adjustment is implemented using a SEM image (an example of a specimen image). More specifically, an amount of deviation of the specimen surface from the reference height is calculated from a shift amount (an image shift amount) between two SEM images captured at different tilt angles. Note that the images used for specimen height adjustment are not limited to SEM images, and the height of the specimen may be adjusted using specimen images obtained by another method.

FIG. 3 illustrates a method for determining an amount of deviation $\Delta Z$ of the specimen surface from the reference height.

The tilt angles at which the two SEM images are captured are assumed to be $\alpha + \beta/2$ and $\alpha - \beta/2$, respectively. In this case, an average of the two tilt angles is $\alpha$, and a difference between the two tilt angles is $\beta$.

At this time, a movement amount $\Delta Y$ of a marker in a Y direction is expressed by expression (1), shown below.

$$\Delta Y = \Delta Z \left( \sin\left( \alpha + \frac{\beta}{2} \right) - \sin\left( \alpha - \frac{\beta}{2} \right) \right) = \Delta Z \cdot 2 \cdot \cos\alpha \cdot \sin\frac{\beta}{2} \quad \cdots (1)$$

Here, $\Delta Z$ is the amount of deviation of the specimen surface from the reference height.

Here, when absolute values of $\alpha$ and $\beta$ are sufficiently small, expression (1) can be approximated by a following expression.

$$\Delta Y = \Delta Z \cdot 2 \cdot \cos\alpha \cdot \sin\frac{\beta}{2}$$

$$= \Delta Z \cdot (\cos\alpha) \cdot \left(2 \cdot \sin\frac{\beta}{2}\right)$$

$$\fallingdotseq \Delta Z \cdot (1) \cdot (\sin\beta)$$

$$= \Delta Z \cdot (\sin\beta) \cdots (2)$$

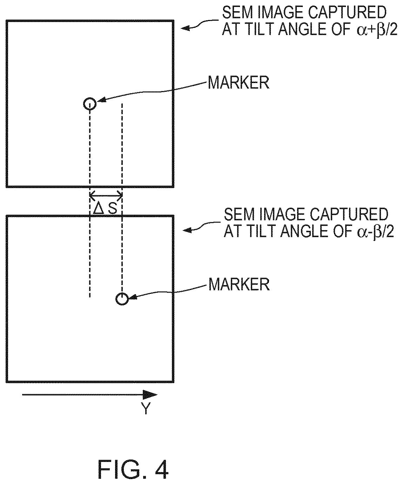

FIG. 4 schematically illustrates the two SEM images used to adjust the height of the specimen.

The movement amount $\Delta Y$ of the marker is obtained from a pixel resolution of the SEM images and a shift amount $\Delta S$ (a pixel value) of the marker between the two SEM images, and expressed as shown below.

$$\Delta Y = (\text{a pixel resolution}) \cdot \Delta S \cdots (3)$$

Note that the shift amount $\Delta S$ of the marker may also be considered as a shift amount (an image shift amount) between the two SEM images.

From expressions (2) and (3), the amount of deviation $\Delta Z$ of the specimen surface from the reference height can be calculated using expression (4), shown below.

$$\Delta Z = \frac{(\text{a pixel resolution}) \cdot \Delta S}{\sin\beta} \cdots (4)$$

Here, the pixel resolution is a length of the SEM image per pixel. Assuming, for example, that an observation range of a SEM image having a magnification of 100x is 960 $\mu$m and the number of pixels of the SEM image in the Y direction is 1024, the pixel resolution is as shown below in table 1.

TABLE 1

| Magnification | 30x | 50x | 100x | 200x | 300x |
|---|---|---|---|---|---|
| Pixel resolution ($\mu$m) | 3.13 | 1.88 | 0.94 | 0.47 | 0.31 |

By moving the specimen S in the Z direction by an amount corresponding to the amount of deviation $\Delta Z$ of the specimen surface, calculated using expression (4), the height of the specimen surface can be adjusted to (aligned with) the position of the tilt center O.

Here, when the specimen S is tilted, the specimen surface tilts, and therefore the SEM image becomes an image that is compressed in the tilt direction. Assuming that the pixel resolution during capture of the SEM images is fixed, the resolution of the specimen surface in the tilt direction reaches a maximum when the tilt angle is zero (when the specimen is not tilted). In terms of the resolution, therefore, it is advantageous for the tilt angles of the SEM images to be small.

The amount by which the marker moves over the SEM image in response to tilting of the specimen surface is commensurate with the sine of the tilt angle. Hence, the amount by which the marker moves per tilt angle unit increases as the tilt angle approaches zero. Therefore, when the difference between the respective tilt angles at which the two SEM images are captured is fixed, the respective tilt angles are preferably close to zero (in other words, the average $\alpha$ of the two tilt angles is preferably close to zero).

The movement amount $\Delta Y$ of the marker increases as the difference ($\beta$) between the tilt angles at which the two SEM images are captured increases. Accordingly, the shift amount $\Delta S$ of the marker between the two SEM images increases as the difference ($\beta$) between the tilt angles increases. As the shift amount $\Delta S$ of the marker between the two SEM images increases, a precision (measurement value/measurement error) with which the position of the marker on the SEM image is measured improves. Therefore, as the difference ($\beta$) between the tilt angles increases, the precision with which the position of the marker on the SEM image is measured improves, leading to an improvement in the precision with which the amount of deviation $\Delta Z$ of the specimen surface is determined.

However, when the movement amount $\Delta Y$ of the marker increases, the marker may move outside the viewing field. In this case, the shift amount $\Delta S$ of the marker between the SEM images cannot be measured.

Hence, in the first embodiment, specimen height adjustment is repeated a plurality of times so that the difference ($\beta$) between the tilt angles increases with each repetition. More specifically, during a first height adjustment, height adjustment is performed by obtaining the two SEM images while the difference ($\beta$) between the tilt angles is small, and then calculating the amount of deviation $\Delta Z$ of the specimen surface roughly. Next, during a second height adjustment, height adjustment is performed by obtaining the two SEM images are obtained after making the difference ($\beta$) between the tilt angles larger than that of the first height adjustment, and then calculating the amount of deviation $\Delta Z$ of the specimen surface. By setting the difference ($\beta$) between the tilt angles at which the two SEM images are obtained for an $n + 1^{th}$ time to be greater than the difference ($\beta$) between the tilt angles at which the two SEM images are obtained for an $n^{th}$ time in this manner, the precision with which the amount of deviation $\Delta Z$ of the specimen surface is determined can be increased by increasing the difference ($\beta$) between the tilt angles while preventing the marker from moving outside the viewing field.

Further, in the first embodiment, specimen height adjustment is repeated a plurality of times so that a magnification at which the SEM images are captured increases with each repetition. In other words, the magnification at which the two SEM images are captured for the $n + 1^{th}$ time is set to be greater than the magnification at which the two SEM images are captured for the $n^{th}$ time. As a result, the pixel resolution improves with each repetition.

By adjusting the height of the specimen repeatedly, the amount of deviation $\Delta Z$ can be reduced with each repetition. Accordingly, an amount by which the specimen stage 50 is moved in order to adjust the height of the specimen also decreases with each repetition of specimen height adjustment, and as a result, the positional precision of the specimen stage 50, which deteriorates in proportion to the movement amount thereof, also improves. Furthermore, when the difference between the movement amount of the specimen stage 50 and the amount of deviation $\Delta Z$ is such that a component thereof that is commensurate with the amount of deviation $\Delta Z$ is dominant, the precision of the amount of deviation $\Delta Z$ is improved exponentially by adjusting the height of the specimen repeatedly.

Pattern recognition using fast Fourier transform (FFT), for example, is used to measure the shift amount $\Delta S$ of the marker from the two SEM images. In this type of pattern recognition, a success rate of the pattern recognition varies greatly depending on the state of the specimen surface (whether or not an appropriate marker exists and so on). It is therefore effective to, for example, obtain sets of two SEM images having a plurality of magnifications (for example, two SEM images having a magnification of 30x, two SEM images having a magnification of 100x, and two SEM images having a magnification of 300x), measure the respective shift amounts $\Delta S$ thereof by executing pattern recognition at each magnification, and estimate the precise shift amount $\Delta S$ from the measurement results (the shift amount at 30x, the shift amount at 100x, and the shift amount at 300x).

When sets of two SEM images are captured at a plurality of magnifications, however, image capture becomes time-consuming.

In the first embodiment, therefore, a plurality of first partial images are generated by cutting out a plurality of areas from one SEM image (a first SEM image) of the two SEM images. Further, a plurality of second partial images are generated by cutting out a plurality of areas corresponding to the plurality of areas cut out from the first SEM image from the other SEM image (a second SEM image) of the two SEM images. The shift amounts $\Delta S$ between the corresponding first partial images and second partial images are then measured with respect to the plurality of first partial images and the plurality of second partial images.

For example, a SEM image (an example of the first SEM image) having a tilt angle $T_0$ (a first tilt angle) and a SEM image (an example of the second SEM image) having a tilt angle $T_1$ (a second tilt angle, where $T_1 \neq T_0$) are respectively captured, whereupon SEM images having different magnifications are generated from the captured SEM images by image processing. By capturing the SEM image having the tilt angle $T_0$ and the SEM image having the tilt angle $T_1$ at a low magnification, and enlarging the images by cutting out identical areas (areas of identical sizes in identical positions) from the respective captured images, a SEM image (an example of the first partial image) having the tilt angle $T_0$ and a desired magnification and a SEM image (an example of the second partial image) having the tilt angle $T_1$ and a desired magnification can be obtained. By cutting out a plurality of areas from the SEM image having the tilt angle $T_0$ and the SEM image having the tilt angle $T_1$ in this manner, respective pluralities of SEM images having the tilt angle $T_0$ and different magnifications and SEM images having the tilt angle $T_1$ and different magnifications can be obtained. Hence, according to the first embodiment, SEM images of various magnifications can be obtained simply by capturing the SEM image having the tilt angle $T_0$ and the SEM image having the tilt angle $T_1$ once each, and as a result, the time required to capture the SEM images can be greatly reduced.

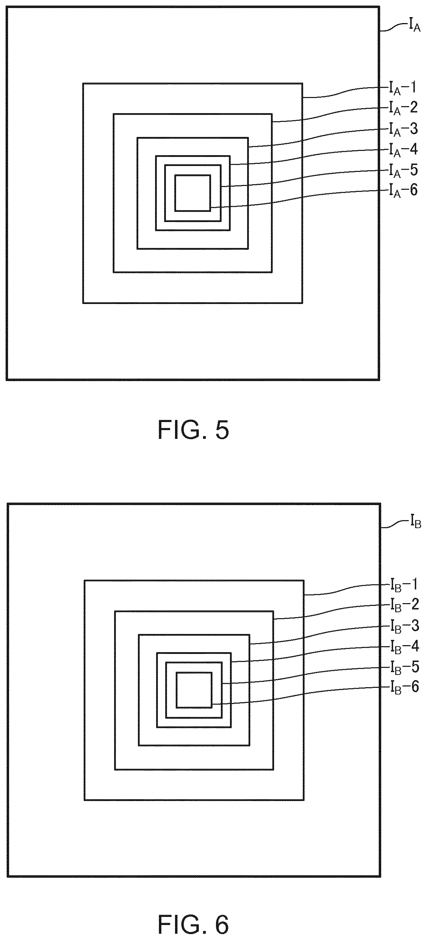

FIG. 5 illustrates a method for generating partial images $I_A$-1, $I_A$-2, $I_A$-3, $I_A$-4, $I_A$-5, and $I_A$-6 from a SEM image $I_A$ having the tilt angle $T_0$.

As illustrated in FIG. 5, the partial images $I_A$-1, $I_A$-2, $I_A$-3, $I_A$-4, $I_A$-5, and $I_A$-6 are generated by cutting out areas having different sizes from the SEM image $I_A$ using the center of the SEM image $I_A$ as the center of the viewing field. In so doing, the SEM image $I_A$ and the six partial images $I_A$-1, $I_A$-2, $I_A$-3, $I_A$-4, $I_A$-5, and $I_A$-6 are obtained from a single image capture operation.

Note that since the sizes of the cut-out areas are different from each other, image processing (digital zooming) is executed to make the six partial images $I_A$-1, $I_A$-2, $I_A$-3, $I_A$-4, $I_A$-5, and $I_A$-6 the same size as the SEM image $I_A$. Accordingly, the SEM image $I_A$ and the six partial images $I_A$-1, $I_A$-2, $I_A$-3, $I_A$-4, $I_A$-5, and $I_A$-6 having the tilt angle $T_0$ may be considered as image having mutually different magnifications.

FIG. 6 illustrates a method for generating partial images $I_B$-1, $I_B$-2, $I_B$-3, $I_B$-4, $I_B$-5, $I_B$-6 from a SEM image $I_B$ having the tilt angle $T_1$.

Similarly to the case in which the partial images $I_A$-1 to $I_A$-6 are generated, the partial images $I_B$-1, $I_B$-2, $I_B$-3, $I_B$-4, $I_B$-5, $I_B$-6 are generated by cutting out areas having different sizes from the SEM image $I_B$ using the center of the SEM image $I_B$ as the center of the viewing field. In so doing, the SEM image $I_B$ and the six partial images $I_B$-1, $I_B$-2, $I_B$-3, $I_B$-4, $I_B$-5, $I_B$-6 are obtained from a single image capture operation. Furthermore, by executing digital zooming to make the six partial images $I_B$-1, $I_B$-2, $I_B$-3, $I_B$-4, $I_B$-5, $I_B$-6 the same size as the SEM image $I_B$, a plurality of partial images having mutually different magnifications can be obtained.

The partial image $I_A$-1 and the partial image $I_B$-1 are corresponding images. In other words, the partial image $I_A$-1 and the partial image $I_B$-1 are images generated by cutting out corresponding areas (in other words, areas of identical sizes in identical positions (at identical coordinates)) from the SEM image $I_A$ and the SEM image $I_B$. Similarly, the partial image $I_A$-2 and the partial image $I_B$-2, the partial image $I_A$-3 and the partial image $I_B$-3, the partial image $I_A$-4 and the partial image $I_B$-4, the partial image $I_A$-5 and the partial image $I_B$-5, and the partial image $I_A$-6 and the partial image $I_B$-6 are respectively corresponding images.

The shift amount $\Delta S$ (also referred to hereafter as a "shift amount $\Delta S$-1") between the partial image $I_A$-1 and the partial image $I_B$-1 can be measured by pattern recognition using FFT or the like, for example. Further, the amount of deviation $\Delta Z$ (also referred to hereafter as an "amount of deviation $\Delta Z$-1") can be calculated from the measured shift amount $\Delta S$-1 using expression (4). The amount of deviation $\Delta Z$-1 may be considered as an amount of deviation of an area (see $I_A$-1 in FIG. 5 and $I_B$-1 in FIG. 6) cut out from the SEM image relative to the reference height. Hence, in the first embodiment, the shift amount $\Delta S$-1 is measured from the partial image $I_A$-1 and the partial image $I_B$-1, and the amount of deviation $\Delta Z$-1 is calculated therefrom. Note that the method for determining the shift amount $\Delta S$ between the partial image $I_A$-1 and the partial image $I_B$-1 is not limited to pattern recognition using FFT or the like.

Similarly, a shift amount $\Delta S$-2 is measured from the partial image $I_A$-2 and the partial image $I_B$-2, whereupon an amount of deviation $\Delta Z$-2 is calculated using expression (4). Similarly, a shift amount $\Delta S$-3 is measured from the partial image $I_A$-3 and the partial image $I_B$-3, whereupon an amount of deviation $\Delta Z$-3 is calculated using expression (4). Similarly, a shift amount $\Delta S$-4 is measured from the partial image $I_A$-4 and the partial image $I_B$-4, whereupon an amount of deviation $\Delta Z$-4 is calculated using expression (4). Similarly, a shift amount $\Delta S$-5 is measured from the partial image $I_A$-5 and the partial image $I_B$-5, whereupon an amount of deviation $\Delta Z$-5 is calculated using expression (4). Similarly, a shift amount $\Delta S$-6 is measured from the partial image $I_A$-6 and the partial image $I_B$-6, whereupon an amount of deviation $\Delta Z$-6 is calculated using expression (4). Also similarly, the shift amount $\Delta S$ (also referred to hereafter as a "shift amount $\Delta S$-0") is measured from the SEM image $I_A$ and the SEM image $I_B$, whereupon the amount of deviation $\Delta Z$ (also referred to hereafter as an "amount of deviation $\Delta Z$-0") is calculated using expression (4).

Here, when a pattern is recognized successfully in at least half of the pattern recognition results (the shift amounts $\Delta S$-0 to $\Delta S$-6), successful pattern recognition results can be obtained from all of the pattern recognition results by employing a median value.

For example, in a case where pattern recognition is executed correctly in four or more of the seven sets of images (the SEM images and the partial images) described above, the median value of the amounts of deviation $\Delta Z$-0 to $\Delta Z$-6 corresponds to a probable value of the amount of deviation $\Delta Z$. Next, a case in which pattern recognition is executed correctly in three or less of the seven sets will be considered. Table 2 illustrates an example of calculation results obtained when the amount of deviation $\Delta Z$ is determined for each area by executing pattern recognition between the respective partial images and the SEM images. Note that at this time, a true value of the amount of deviation $\Delta Z$ is 50 $\mu$m.

TABLE 2

| Magnification ratio | $\Delta Z$ ($\mu$m) |
| --- | --- |
| 30x/30x | 52 |
| 50x/30x | 50 |
| 70x/30x | 90 |

(continued)

| Magnification ratio | $\Delta Z\,(\mu m)$ |
|---|---|
| 100x/30x | 45 |
| 150x/30x | 10 |
| 200x/30x | 12 |
| 300x/30x | 11 |

Note that the magnification ratios in table 2 are magnification ratios employed to return the partial images cut out from the SEM image to the size of the original SEM image. For example, 50x/30x indicates a case in which the magnification of the partial image is 50x and the magnification of the original SEM image is 30x such that the magnification ratio is 50x/30x = 1.66 ... x.

The values furthest removed from the true value ($\Delta Z$ = 50 $\mu$m) are assumed to indicate pattern recognition failures. For example, assuming that values deviating from the true value by at least $\pm 10$ $\mu$m indicate failures, there are four failures, namely 90 $\mu$m, 10 $\mu$m, 12 $\mu$m, and 11 $\mu$m, and three successes, namely 52 $\mu$m, 50 $\mu$m, and 45 $\mu$m. Hence, although there are only three successes, the median value of the amount of deviation $\Delta Z$ determined from the seven sets of images is 45 $\mu$m.

Therefore, even when the number of pattern recognition failures is large, as long as the results thereof deviate to both a positive side and a negative side of the true value, the median value takes a value indicating successful pattern recognition. Even when pattern recognition fails, the resulting values thereof often deviate to both the positive side and the negative side of the true value, and therefore no problem occurs even when the number of successes is smaller than the number of failures.

Hence, by setting the median value of the calculated amounts of deviation $\Delta Z$-0 to $\Delta Z$-6 as the amount of deviation $\Delta Z$, the amount of deviation $\Delta Z$ can be determined accurately.

Note that instead, the median value of the pattern recognition results (the shift amounts $\Delta S$-0 to $\Delta S$-6) may be set as the shift amount $\Delta S$, and a calculation result obtained by inserting the shift amount $\Delta S$ into expression (4) may be set as the amount of deviation $\Delta Z$.

(2) Processing

Next, processing executed by the control section 80 of the surface analysis device 100 according to the first embodiment will be described. In the surface analysis device 100, specimen height adjustment is performed automatically.

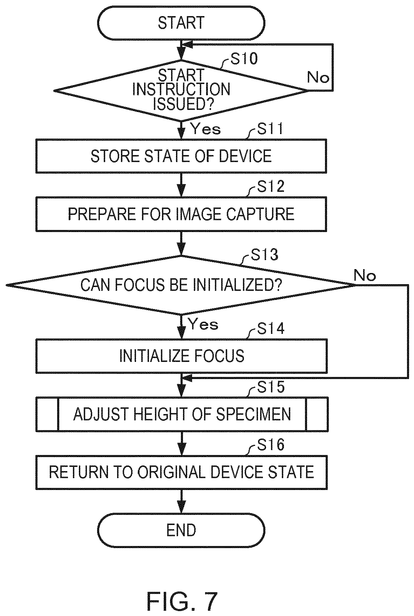

FIG. 7 is a flowchart illustrating an example of a flow of the processing executed by the control section 80 of the surface analysis device 100.

First, the control section 80 determines whether or not a user has issued an instruction (a start instruction) to start adjusting the height of the specimen (S10), and then waits for the start instruction to be issued (No in S10). The control section 80 determines that the user has issued the start instruction when, for example, an operation is performed to press a measurement start button or a start instruction is input from an input device or the like.

After determining that the start instruction has been issued (Yes in S10), the control section 80 executes processing to store the current state of the device in the storage section 90 (S11). The state of the device indicates the magnification, the contrast, the brightness, the ON/OFF state of a detector (PCD) for measuring the probe current, and so on. By storing the state of the device, the device can be returned to its original state when height adjustment is complete or when height adjustment fails.

Next, the control section 80 controls the respective parts of the surface analysis device 100 such that the SEM images can be captured (S12). For example, the control section 80 switches the PCD OFF (removes the PCD from the optical axis), switches a beam shutter OFF, switches an ion gauge of a specimen chamber OFF, and so on.

Here, the objective lens 30 includes hysteresis, and therefore, once a focus of the objective lens 30 has been initialized, it may be impossible to return the objective lens 30 to its original state. Hence, the control section 80 initializes the focus of the objective lens 30 (S14) only when focus initialization is set to be possible (Yes in S13). Whether or not focus initialization is possible may be set by the user in advance.

After initializing the focus of the objective lens 30 (S14), or when initialization is set to be impossible (No in S13), the control section 80 executes specimen height adjustment processing (S15). The specimen height adjustment processing will be described in detail below.

Following the specimen height adjustment processing (S15), the control section 80 executes control to return the device to its original state (S16). More specifically, the control section 80 reads information indicating the state of the device, which is stored in the storage section 90 in step S11, and controls the respective parts of the device on the basis of the information indicating the state of the device. The control section 80 then terminates the processing.

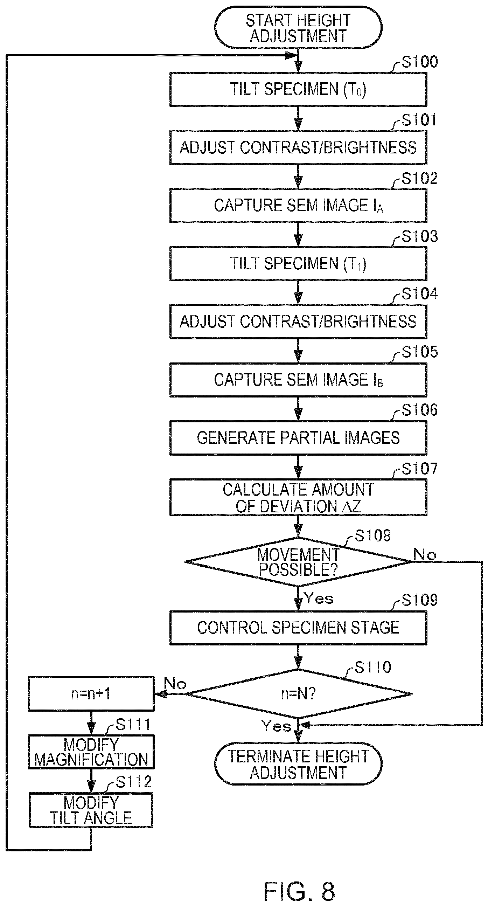

FIG. 8 is a flowchart illustrating an example of a flow of the specimen height adjustment processing executed by the control section 80.

The control section 80 controls the specimen stage 50 so that the tilt angle of the specimen S reaches the tilt angle $T_0$ (S100). Next, the control section 80 adjusts the contrast and the brightness of the SEM image (S 101). The contrast and the brightness are adjusted using a well-known, automatic contrast/brightness adjustment function.

Next, the control section 80 executes control to capture a SEM image (S102). As a result, a SEM image (the SEM image $I_A$) is stored in the frame memory 70. The control section 80 then executes processing to store the SEM image $I_A$ stored in the frame memory 70 in the storage section 90.

Next, the control section 80 controls the specimen stage 50 so that the tilt angle of the specimen S reaches the tilt angle $T_1$ (S103). Next, the control section 80 adjusts the contrast and the brightness of the SEM image (S 104), and then executes control to capture a SEM image (S105). As a result, a SEM image (the SEM image $I_B$) is stored in the frame memory 70. The control section 80 then executes processing to store the SEM image $I_B$ stored in the frame memory 70 in the storage section 90.

By adjusting the contrast and the brightness (S101, S104) when capturing the SEM images $I_A$, $I_B$, differences in the contrast and the brightness caused by the difference in the tilt angle can be reduced. As a result, the likelihood of pattern recognition failure can be reduced.

Here, the SEM image $I_A$ and the SEM image $I_B$ are captured by high-speed scanning in which the electron beam EB scans the images at a higher speed than during normal image capture. As a result, the measurement time can be shortened. During high-speed scanning, however, an SN ratio of the captured SEM image deteriorates, leading to an increase in the likelihood of failure during pattern recognition using FFT. Therefore, the control section 80 executes image processing (noise removal or the like) on the obtained SEM images. As a result, the likelihood of pattern recognition failure can be reduced.

Further, an SEM image captured in a state where the specimen S is tilted is distorted (compressed) in the tilt direction. Therefore, the control section 80 executes image distortion correction (image processing) corresponding to the tilt angle on the obtained SEM images $I_A$ and $I_B$. As a result, the likelihood of pattern recognition failure can be reduced.

Next, the control section 80 generates the partial images $I_A$-1 to $I_A$-6 from the SEM image $I_A$ and generates the partial images $I_B$-1 to $I_B$-6 from the SEM image $I_B$ (S106). As illustrated in FIG. 5, the control section 80 generates the partial images $I_A$-1 to $I_A$-6 by cutting out areas of different sizes from the SEM image $I_A$ using the center of the SEM image $I_A$ as the center of the viewing field. As illustrated in FIG. 6, the control section 80 generates the partial images $I_B$-1 to $I_B$-6 by cutting out areas of different sizes from the SEM image $I_B$ using the center of the SEM image $I_B$ as the center of the viewing field.

Next, the control section 80 calculates the amount of deviation $\Delta Z$ (S107) by measuring the shift amounts (the image shift amounts) between corresponding partial images in relation to the partial images $I_A$-1 to $I_A$-6 and the partial images $I_B$-1 to $I_B$-6, and in relation to the SEM image $I_A$ and the SEM image $I_B$.

More specifically, the control section 80 measures the shift amount $\Delta S$ between the corresponding partial images $I_A$-1 and $I_B$-1 by pattern recognition, and then calculates the amount of deviation $\Delta Z$ (the amount of deviation $\Delta Z$-1) using expression (4). By executing this processing on the partial images $I_A$-1 to $I_A$-6 and the partial images $I_B$-1 to $I_B$-6 and on the SEM image $I_A$ and the SEM image $I_B$, the control section 80 determines the amounts of deviation $\Delta Z$-0 to $\Delta Z$-6. The control section 80 then determines the median value of the amounts of deviation $\Delta Z$-0 to $\Delta Z$-6, and sets the median value as the amount of deviation $\Delta Z$.

Next, the control section 80 determines whether or not the specimen stage 50 can be moved by the determined amount of deviation $\Delta Z$ (S108). More specifically, the control section 80 determines whether or not a sum of the current position of the specimen stage 50 and the amount of deviation $\Delta Z$ is within a movable range of the specimen stage 50. Note that the movable range of the specimen stage 50 is a range within a Z direction movable range of the specimen stage 50, in which the specimen S does not collide with the secondary electron detector 60, the electron spectroscope 62, or another member.

After determining that the specimen stage 50 can be moved (Yes in S108), the control section 80 executes control to move the specimen stage 50 in the Z direction by the amount of deviation $\Delta Z$ (S109).

Next, the control section 80 determines whether or not a number of repetitions n of the processing for obtaining the SEM images $I_A$ and $I_B$ (S100 to S105), the processing for calculating the amount of deviation $\Delta Z$ (S106, S107), and the processing for controlling the specimen stage 50 (S109) has reached a set target number N (S110).

After determining that the number of repetitions n has not reached the target number N (No in S110), the control section 80 modifies the imaging magnification (S111) and the tilt angles $T_0$ and $T_1$ (S112) of the SEM images.

More specifically, the control section 80 sets the imaging magnification of the SEM images during the $n + 1^{th}$ imaging operation to be larger than the imaging magnification of the SEM images during the $n^{th}$ imaging operation. Further, the control section 80 sets the difference ($|T_0 - T_1|$) between the tilt angle $T_0$ at which the SEM image $I_A$ is captured and the tilt angle $T_1$ at which the SEM image $I_B$ is captured during the $n + 1^{th}$ imaging operation to be larger

than the difference ($|T_0 - T_1|$) between the tilt angle $T_0$ at which the SEM image $I_A$ is captured and the tilt angle $T_1$ at which the SEM image $I_B$ is captured during the $n^{th}$ imaging operation.

Note that there are no particular limitations on the order in which the imaging magnification (S111) and the tilt angles (S112) of the SEM images are modified, and the imaging magnification may be modified after modifying the tilt angles.

Next, the control section 80 returns to step S100 and executes the processing for obtaining the SEM images $I_A$ and $I_B$ (S100 to S105), the processing for calculating the amount of deviation $\Delta Z$ (S106, S107), and the processing for controlling the specimen stage 50 (S109) again.

The control section 80 executes the processing for obtaining the SEM images $I_A$ and $I_B$ (S100 to S105), the processing for calculating the amount of deviation $\Delta Z$ (S106, S107), and the processing for controlling the specimen stage 50 (S109) repeatedly while modifying the imaging magnification and the tilt angles (S111, S112) until the number of repetitions n reaches the set target number N.

When the number of repetitions n reaches the set target number N (Yes in S110) or it is determined in step S108 that the specimen stage 50 cannot be moved by the determined amount of deviation $\Delta Z$ (No in S108), the control section 80 terminates the specimen height adjustment processing.

(3) Features

The surface analysis device 100 according to the first embodiment has the following features, for example.

The surface analysis device 100 includes the specimen stage 50 having the height direction moving mechanism for moving the specimen S in the height direction and the tilting mechanism for tilting the specimen S, and the control section 80 for controlling the specimen stage 50. The control section 80 executes specimen image acquisition processing (S100 to S105) for obtaining the SEM image $I_A$, which is captured with the tilt angle of the specimen S as the tilt angle $T_0$, and the SEM image $I_B$, which is captured with the tilt angle of the specimen S as the tilt angle $T_1$, deviation amount calculation processing (S106, S107) for calculating, from the SEM image $I_A$ and the SEM image $I_B$, the amount of deviation $\Delta Z$ of the specimen surface from the reference height, and height control processing (S109) for controlling the specimen stage 50 on the basis of the amount of deviation $\Delta Z$ of the specimen surface. In the deviation amount calculation processing, the plurality of partial images $I_A$-1 to $I_A$-6 are generated by cutting out a plurality of areas from the SEM image $I_A$, the plurality of partial images $I_B$-1 to $I_B$-6 are generated by cutting out from the SEM image $I_B$ a plurality of areas corresponding to the plurality of areas cut out from the SEM image $I_A$ (S106), and the amount of deviation $\Delta Z$ of the specimen surface is calculated by measuring, with respect to the SEM image $I_A$ and the plurality of partial images $I_A$-1 to $I_A$-6 and the SEM image $I_B$ and the plurality of partial images $I_B$-1 to $I_B$-6, respective shift amounts between corresponding partial images (S107).

In the surface analysis device 100, the height of the specimen can be adjusted automatically by the processing executed by the control section 80, described above, and therefore the height of the specimen can be adjusted easily. Further, in the surface analysis device 100, as described above, the control section 80 generates the plurality of partial images $I_A$-1 to $I_A$-6 and partial images $I_B$-1 to $I_B$-6 from the SEM image $I_A$ and the SEM image $I_B$, and calculates the amount of deviation $\Delta Z$ of the specimen surface by measuring the shift amounts between corresponding partial images in relation to these partial images. In so doing, the amount of deviation $\Delta Z$ can be determined accurately. Hence, according to the surface analysis device 100, the height of the specimen can be adjusted easily and accurately. Furthermore, SEM images of various magnifications can be obtained simply by capturing a SEM image having the tilt angle $T_0$ and a SEM image having the tilt angle $T_1$ once each, and as a result, the time required to capture the SEM images can be greatly reduced.

In the surface analysis device 100, the control section 80 executes determination processing (S110) for determining whether or not the number of repetitions n of the specimen image acquisition processing (S100 to S105), the deviation amount calculation processing (S106, S107), and the height control processing (S109) has reached the target number N, and after determining that the target number N has not been reached, executes the specimen image acquisition processing, deviation amount calculation processing, and height control processing again. As a result, the height of the specimen can be adjusted more accurately.

In the surface analysis device 100, the control section 80 sets the difference ($|T_0 - T_1|$) between the tilt angle $T_0$ and the tilt angle $T_1$ when the SEM image $I_A$ and the SEM image $I_B$ are captured for the n + $1^{th}$ time to be larger than the difference ($|T_0 - T_1|$) between the tilt angle $T_0$ and the tilt angle $T_1$ when the SEM image $I_A$ and the SEM image $I_B$ are captured for the $n^{th}$ time. As a result, the precision with which the position of the marker on the SEM image is measured can be improved with each repetition of the specimen image acquisition processing, deviation amount calculation processing, and height control processing, leading to an improvement in the precision with which the amount of deviation $\Delta Z$ is determined. Hence, according to the surface analysis device 100, the precision with which the amount of deviation $\Delta Z$ is determined can be improved while preventing the amount of movement of the viewing field between partial images from becoming so large that the shift amount between the partial images cannot be measured.

In the surface analysis device 100, the control section 80 sets the magnification at which the SEM image $I_A$ and the SEM image $I_B$ are captured for the n + 1th time to be larger than the magnification at which the SEM image $I_A$ and the SEM image $I_B$ are captured for the nth time. As a result, the pixel resolution (see expression (4)) can be improved with each repetition of the specimen image acquisition processing, deviation amount calculation processing, and height control processing. Hence, according to the surface analysis device 100, the pixel resolution can be improved while preventing the amount of movement of the viewing field between partial images from becoming so large that the shift amount between the partial images cannot be measured.

In the surface analysis device 100, the control section 80, during the deviation amount calculation processing, generates the plurality of partial images $I_A$-1 to $I_A$-6 by cutting out areas having different sizes from the SEM image $I_A$ using the center of the SEM image $I_A$ as the center of the viewing field, and generates the plurality of partial images $I_B$-1 to $I_B$-6 by cutting out areas having different sizes from the SEM image $I_B$ using the center of the SEM image $I_B$ as the center of the viewing field. Thus, SEM images of various magnifications can be obtained simply by capturing a SEM image having the tilt angle $T_0$ and a SEM image having the tilt angle $T_1$ once each, and as a result, the time required to capture the SEM images can be greatly reduced.

In the surface analysis device 100, the control section 80, during the deviation amount calculation processing, executes processing on the SEM image $I_A$ and the plurality of partial images $I_A$-1 to $I_A$-6 and on the SEM image $I_B$ and the plurality of partial images $I_B$-1 to $I_B$-6 to calculate amounts of deviation of the cut-out areas from the reference height by measuring the respective shift amounts between corresponding partial images, determines a median value from the amounts of deviation $\Delta Z$-0 to $\Delta Z$-6 of the cut-out areas from the reference height, calculated for each area, and sets the determined median value as the amount of deviation $\Delta Z$ of the specimen surface. Hence, as described above, the amount of deviation $\Delta Z$ can be determined accurately.

In the surface analysis device 100, the reference height is the position of the tilt center O when the specimen S is tilted. In the surface analysis device 100, therefore, as long as the height of the specimen S has been adjusted (in other words, as long as the specimen surface is positioned at the reference height), the viewing field (the image center) does not move even when the specimen S is tilted.

The specimen height adjustment method according to the first embodiment is executed by the surface analysis device having the specimen stage 50 that includes the height direction moving mechanism for moving the specimen S in the height direction and the tilting mechanism for tilting the specimen S, and includes the steps of obtaining the SEM image $I_A$, which is captured with the tilt angle of the specimen S as the tilt angle $T_0$, and the SEM image $I_B$, which is captured with the tilt angle of the specimen S as the tilt angle $T_1$, calculating, from the SEM image $I_A$ and the SEM image $I_B$, the amount of deviation $\Delta Z$ of the specimen surface from the reference height, and adjusting the height of the specimen on the basis of the amount of deviation $\Delta Z$ of the specimen surface. In the step for calculating the amount of deviation $\Delta Z$ of the specimen surface, the plurality of partial images $I_A$-1 to $I_A$-6 are generated by cutting out a plurality of areas from the SEM image $I_A$, the plurality of partial images $I_B$-1 to $I_B$-6 are generated by cutting out from the SEM image $I_B$ a plurality of areas corresponding to the plurality of areas cut out from the SEM image $I_A$, and the amount of deviation of the specimen surface is calculated by measuring, with respect to the SEM image $I_A$ and the plurality of partial images $I_A$-1 to $I_A$-6 and the SEM image $I_B$ and the plurality of partial images $I_B$-1 to $I_B$-6, respective shift amounts between corresponding partial images.

Hence, with the specimen height adjustment method according to the first embodiment, the height of the specimen S can be adjusted easily and accurately. Moreover, SEM images of various magnifications can be obtained simply by capturing a SEM image having the tilt angle $T_0$ and a SEM image having the tilt angle $T_1$ once each, and therefore the time required to capture the SEM images can be greatly reduced.


2. Second Embodiment


2.1. Surface Analysis Device

Next, a surface analysis device according to the second embodiment will be described. The surface analysis device according to the second embodiment is configured identically to the surface analysis device 100 illustrated in FIG. 1, and therefore illustration and description thereof have been omitted.


2.2. Specimen Height Adjustment Method

Next, a specimen height adjustment method according to the second embodiment will be described.

In the second embodiment, the processing executed by the control section 80 differs from the processing executed by the control section 80 of the surface analysis device 100 according to the first embodiment, described above, in that the control section 80 determines whether or not the median value determined from the amounts of deviation $\Delta Z$-0 to $\Delta Z$-6 calculated in the respective areas is probable. Points that differ from the example of the surface analysis device 100 according to the first embodiment will be described below, while description of points that are similar has been omitted.

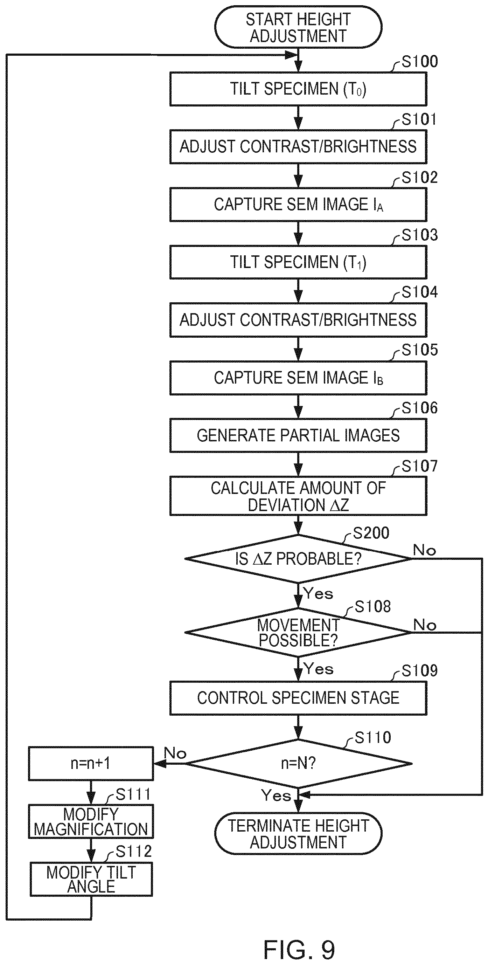

FIG. 9 is a flowchart illustrating an example of a flow of specimen height adjustment processing executed by the control section 80 of the surface analysis device according to the second embodiment. Note that in FIG. 9, steps in which identical processing to FIG. 8 is executed have been allocated identical step numbers.

In the second embodiment, the control section 80 determines whether or not the determined amount of deviation $\Delta Z$ is probable (S200) after executing the deviation amount calculation processing (S106, S107).

More specifically, in the deviation amount calculation processing, the control section 80 determines a median value from the amounts of deviation $\Delta Z$-0 to $\Delta Z$-6 of the cut-out areas from the reference height, an amount of deviation having been calculated for each area, and sets the determined median value as the amount of deviation $\Delta Z$ of the specimen surface (S107). Next, when the median value has been set as the amount of deviation $\Delta Z$ and at least a predetermined number of the amounts of deviation $\Delta Z$-0 to $\Delta Z$-6 calculated from the other areas exists within an error range of the amount of deviation $\Delta Z$, the control section 80 determines that the determined amount of deviation is probable.

The determination processing will now be described using table 2, shown above, as an example. In the example shown on table 2, the true value of the amount of deviation $\Delta Z$ is 50 $\mu$m and the median value is 45 $\mu$m. Here, the error range of the amount of deviation $\Delta Z$ is set. For example, the error range is set at 20%. When the determined median value is set as the amount of deviation $\Delta Z$, the amount of deviation $\Delta Z$, including the error range, is $\Delta Z$ = 45 $\mu$m $\pm$ 9 $\mu$m.

When pattern recognition is successful so that an appropriate amount of deviation is calculated, a different amount of deviation exists within the error range. In the example shown on table 2, two amounts of deviation (52 $\mu$m and 50 $\mu$m) determined from other areas (partial images) are within the range of $\Delta Z$ = 45 $\mu$m $\pm$ 9 $\mu$m. Hence, the amount of deviation $\Delta Z$ = 45 $\mu$m is determined to be probable.

When the number of amounts of deviation included in the error range is zero, this may mean that either pattern recognition was successful only at the median value, or that pattern recognition failed at the median value. As long as the number of partial images is sufficient, the probability of pattern recognition being successful only at the median value is extremely low. Therefore, when the number of amounts of deviation included in the error range is zero, the determined amount of deviation $\Delta Z$ is determined to be improbable.

The error range may be set as desired by the user, for example. Alternatively, the error range may be set as a function of the amount of deviation $\Delta Z$. This function may be optimized for each device. For example, the error range may be defined according to a mechanical precision, such as a movement reproducibility, of the specimen stage 50. In the above example, the error range is set at 20%, and therefore the function of the error range is f ($\Delta Z$) = $\Delta Z \times 0.2$.

Further, the number (the aforementioned predetermined number) of amounts of deviation calculated from the other areas and included in the error range may be set as desired by the user, for example. Alternatively, the number of amounts of deviation calculated from the other areas and included in the error range may be set automatically in accordance with the number of generated partial images.

The error range and the number of amounts of deviation included in the error range may be set by performing experiments on an actual device in advance and ascertaining optimum values and functions.

After determining that the determined amount of deviation $\Delta Z$ is probable (Yes in S200), the control section 80 determines whether or not the specimen stage 50 can be moved by the determined amount of deviation $\Delta Z$ (S108). Further, after determining that the determined amount of deviation $\Delta Z$ is improbable (No in S200), the control section 80 terminates the specimen height adjustment processing.

In the surface analysis device according to the second embodiment, the determination processing (S200) for determining whether or not the determined amount of deviation $\Delta Z$ of the specimen surface is probable is executed after the deviation amount calculation processing (S106, S107) and before the height control processing (S109), and in the determination processing (S200), the determined amount of deviation $\Delta Z$ of the specimen surface is determined to be probable when the median value determined from the amounts of deviation $\Delta Z$-0 to $\Delta Z$-6 calculated from the respective areas has been set as the amount of deviation $\Delta Z$ of the specimen surface and at least a predetermined number of amounts of deviation calculated from the other areas exists within the set error range of the amount of deviation $\Delta Z$ of the specimen surface. Hence, when pattern recognition fails such that the amount of deviation $\Delta Z$ of the specimen surface is inaccurate, it is possible to prevent the height of the specimen from being adjusted on the basis of the inaccurate amount of deviation $\Delta Z$.

3. Third Embodiment

3.1. Surface Analysis Device

Next, a surface analysis device according to the third embodiment will be described. The surface analysis device according to the third embodiment is configured identically to the surface analysis device 100 illustrated in FIG. 1, and therefore illustration and description thereof have been omitted.

3.2. Specimen Height Adjustment Method

Next, a specimen height adjustment method according to the third embodiment will be described.

In the first and second embodiments, described above, the control section 80 executes the processing for adjusting the height of the specimen repeatedly up to the set target number of times. In the third embodiment, on the other hand, the control section 80 executes determination processing for determining whether or not an absolute value $|\Delta Z|$ of the amount of deviation calculated in the deviation amount calculation processing (S106, S107) is equal to or smaller than a predetermined value, and after determining that the absolute value $|\Delta Z|$ of the calculated amount of deviation is not equal to or smaller than a predetermined value, executes the height control processing and then repeats the specimen image acquisition processing and the deviation amount calculation processing. In other words, in the third embodiment, the height of the specimen is adjusted repeatedly until the absolute value $|\Delta Z|$ of the amount of deviation falls to or below the predetermined value.

Points that differ from the example of the surface analysis device 100 according to the first embodiment will be described below, while description of points that are similar has been omitted.

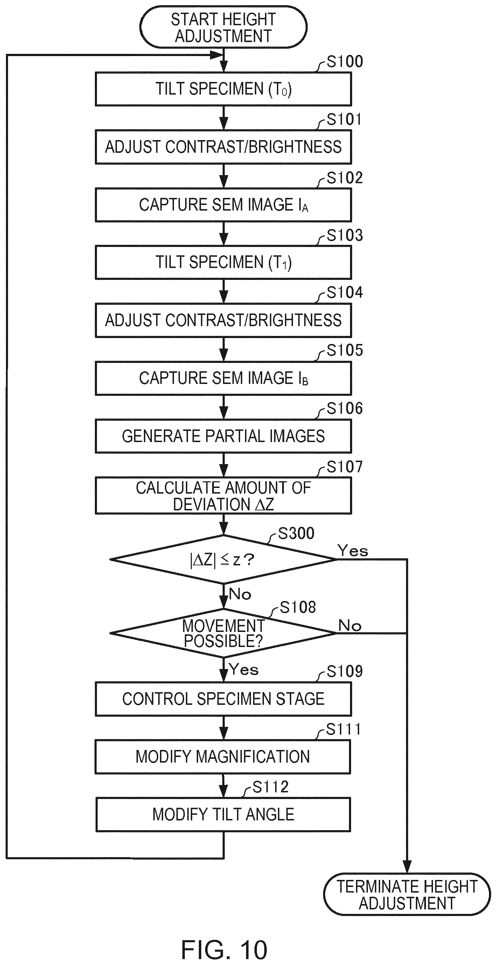

FIG. 10 is a flowchart illustrating an example of a flow of specimen height adjustment processing executed by the control section 80 of the surface analysis device according to the third embodiment. Note that in FIG. 10, steps in which identical processing to FIG. 8 is executed have been allocated identical step numbers.

In the third embodiment, the control section 80 determines whether or not the absolute value $|\Delta Z|$ of the calculated amount of deviation is equal to or smaller than a predetermined value z (S300) after executing the deviation amount calculation processing (S106, S107).

More specifically, in the deviation amount calculation processing, the control section 80 determines a median value from the amounts of deviation $\Delta Z$-0 to $\Delta Z$-6 of the cut-out areas from the reference height, an amount of deviation having been calculated for each area, and sets the determined median value as the amount of deviation $\Delta Z$ of the specimen surface (S107). Next, the control section 80 determines whether or not the absolute value $|\Delta Z|$ of the amount of deviation obtained in step S107 is equal to or smaller than the predetermined value z (S300). The predetermined value z can be set as appropriate in accordance with the required height adjustment precision.

After determining that the absolute value $|\Delta Z|$ of the amount of deviation is not equal to or smaller than the predetermined value z (in other words, when $|\Delta Z| > z$) (No in S300), the control section 80 determines whether or not the specimen stage 50 can be moved by the determined amount of deviation $\Delta Z$ (S108). After determining that the specimen stage 50 can be moved (Yes in S108), the control section 80 executes the processing (S109) for controlling the specimen stage 50.

Further, after determining that the absolute value $|\Delta Z|$ of the amount of deviation is equal to or smaller than the predetermined value z (in other words, when $|\Delta Z| \leq z$) (No in S300), the control section 80 terminates the specimen height adjustment processing.

In the surface analysis device according to the third embodiment, the control section 80 executes the determination processing (S300) for determining whether or not the absolute value $|\Delta Z|$ of the amount of deviation of the specimen surface, which is calculated in the deviation amount calculation processing (S106, S107), is equal to or smaller than the predetermined value z after executing the deviation amount calculation processing, and after determining that the absolute value $|\Delta Z|$ of the amount of deviation of the specimen surface is not equal to or smaller than the predetermined value z (No in S300), executes the height control processing (S109) and then repeats the specimen image acquisition processing (S100 to S105) and the deviation amount calculation processing. As a result, the height of the specimen can be adjusted more accurately.

Note that above, a case in which the determination processing (S300) is applied to the specimen height adjustment method according to the first embodiment, illustrated in FIG. 8, was described, but the determination processing (S300) may be applied similarly to the specimen height adjustment method according to the second embodiment, illustrated in FIG. 9.

4. Modified Examples

The invention is not limited to the above-described embodiments, and various modifications can be made within the scope of the invention.

4.1. First Modified Example

For example, in the above embodiments, the plurality of partial images $I_A$-1 to $I_A$-6 are generated by cutting out areas of different sizes from the SEM image $I_A$ using the center of the SEM image $I_A$ as the center of the viewing field (see FIG. 5), and the plurality of partial images $I_B$-1 to $I_B$-6 are generated by cutting out areas of different sizes from the SEM image $I_B$ using the center of the SEM image $I_B$ as the center of the viewing field (see FIG. 6), but the method of generating partial images is not limited thereto.

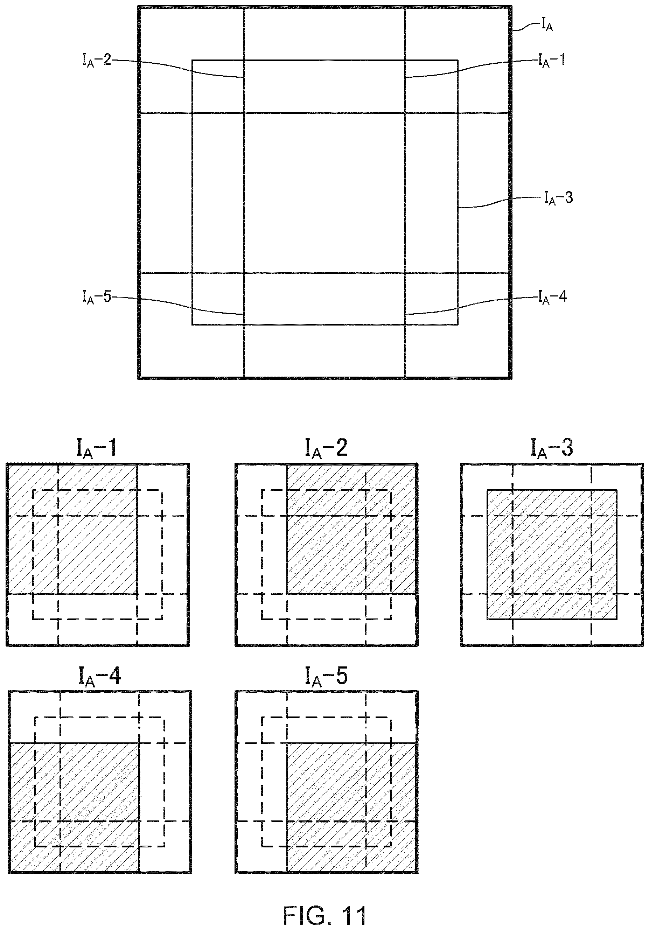

FIGS. 11 to 14 illustrate a method for generating partial images $I_A$-1 to $I_A$-20 from the SEM image $I_A$ having the tilt angle $T_0$. Note that FIGS. 11 to 14 illustrate positions of the respective partial images, and in these figures, the respective partial images are indicated by shading.

In this modified example, a plurality of partial images are generated by cutting out a plurality of areas of a first size and having mutually different viewing centers from the SEM image $I_A$, and then cutting out a plurality of areas of a second size which is different from the first size, and having mutually different viewing field centers from the SEM image $I_A$. Further, a larger number of partial images may be generated by repeating this process.

In the example illustrated in FIGS. 11 to 14, first, as illustrated in FIG. 11, five areas having a size that equals the size of the SEM image $I_A$ when magnified by $\sqrt{2}x$ and having mutually different viewing field centers are cut out from the SEM image $I_A$. As a result, when the magnification of the original SEM image $I_A$ is set at $M_Ax$, partial images $I_A$-1 to $I_A$-5 having a magnification of $\sqrt{2} \times M_Ax$ can be generated.

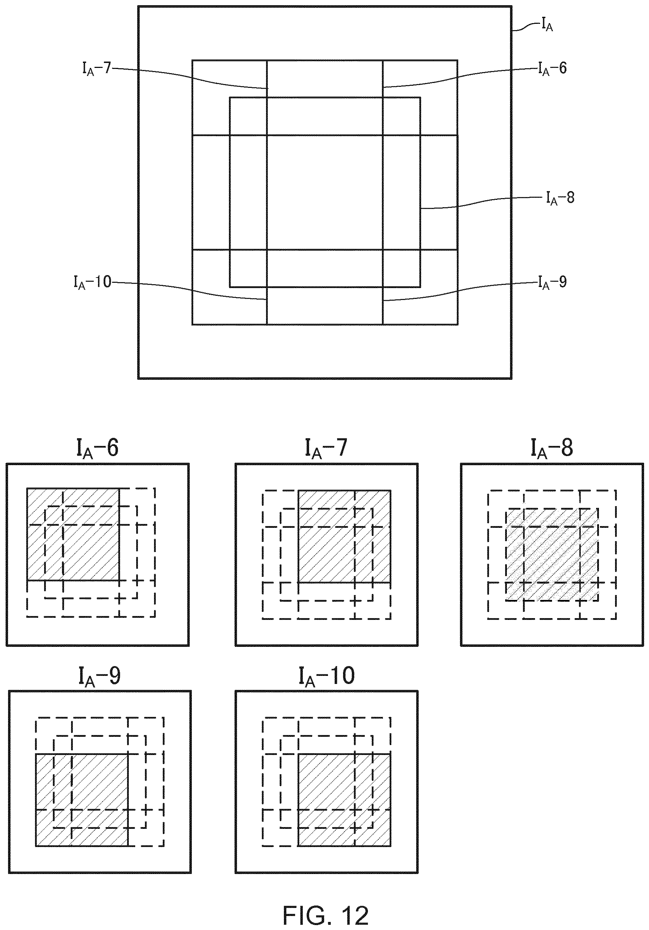

Next, as illustrated in FIG. 12, five areas having a size that equals the size of the SEM image $I_A$ when magnified by 2x and having mutually different viewing field centers are cut out from the SEM image $I_A$. As a result, partial images $I_A$-6 to $I_A$-10 having a magnification of $2 \times M_Ax$ can be generated.

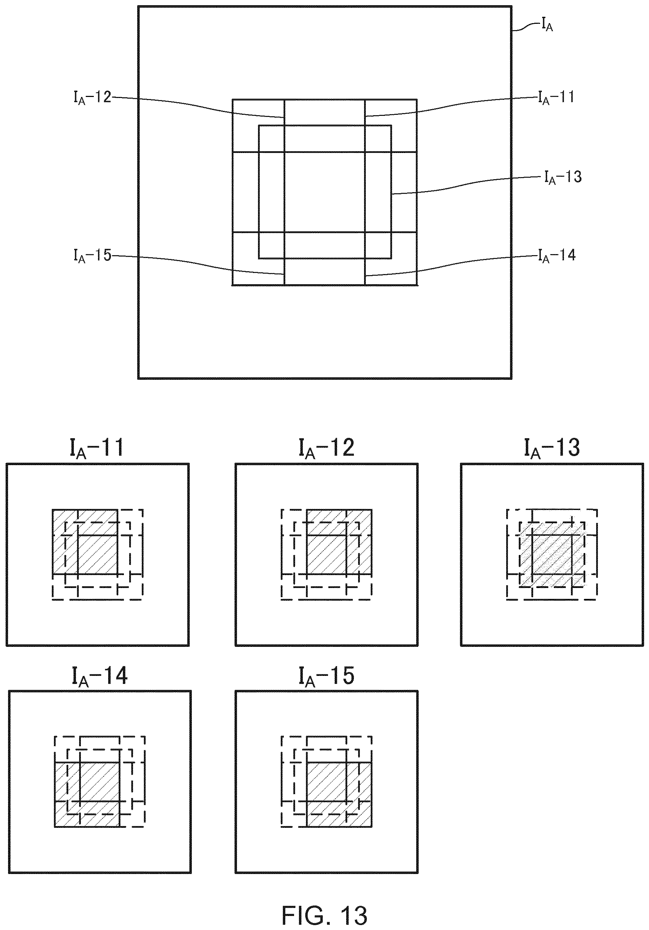

Next, as illustrated in FIG. 13, five areas having a size that equals the size of the SEM image $I_A$ when magnified by $2\sqrt{2}x$ and having mutually different viewing field centers are cut out from the SEM image $I_A$. As a result, partial images $I_A$-11 to $I_A$-15 having a magnification of $2\sqrt{2} \times M_Ax$ can be generated.

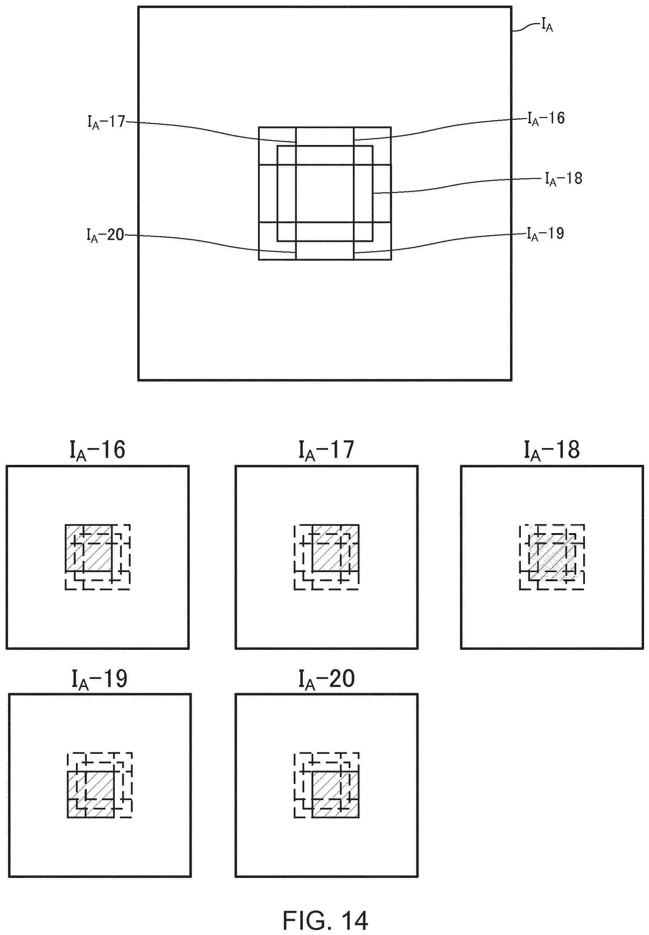

Next, as illustrated in FIG. 14, five areas having a size that equals the size of the SEM image $I_A$ when magnified by 4x and having mutually different viewing field centers are cut out from the SEM image $I_A$. As a result, partial images $I_A$-16 to $I_A$-20 having a magnification of $4 \times M_Ax$ can be generated.

Hence, 20 partial images can be generated from the single SEM image $I_A$. Although not shown in the figures, by executing similar processing on the SEM image $I_B$, 20 partial images can be generated from the single SEM image $I_B$.

According to this modified example, therefore, a large number of partial images can be generated from the single SEM images $I_A$, $I_B$. Further, according to this modified example, the SEM image is cut in such a way that the partial images have mutually different viewing field centers, and therefore various different parts of the SEM image can be cut out. Accordingly, the number of partial images including a marker (a characteristic pattern that is useful during pattern recognition or the like) increases, leading to an increases in the number of pattern recognition successes, and as a result, the amount of deviation $\Delta Z$ can be calculated even more accurately.

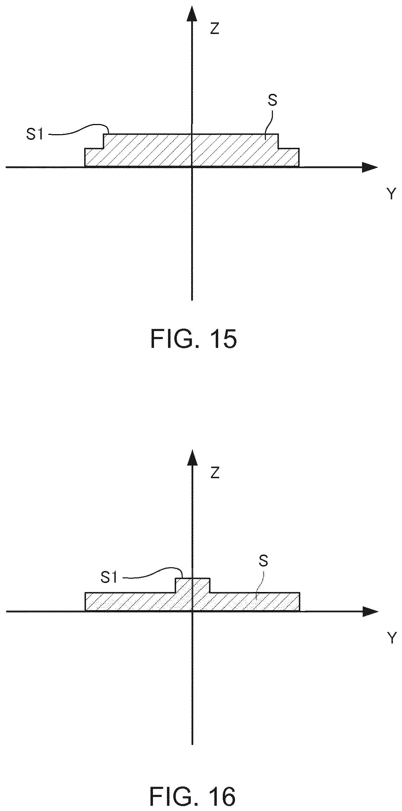

FIGS. 15 and 16 are schematic sectional views illustrating examples of the specimen S.

When a flat surface S1 including a position (a position that serves as the center of the SEM image) on the specimen surface that intersects the Z axis (the optical axis) is comparatively large, as illustrated in FIG. 15, the partial image generation method illustrated in FIGS. 11 to 14 is effective. When, on the other hand, the flat surface S1 including the position on the specimen surface that intersects the Z axis (the optical axis) is comparatively small, as illustrated in FIG. 16, the partial image generation method illustrated in FIGS. 5 and 6 is effective. The reason for this is that when the partial image generation method illustrated in FIGS. 11 to 14 is used, the proportion of areas in and close to the center of the viewing field of the SEM image, among the generated plurality of partial images, is smaller than when the partial image generation method illustrated in FIGS. 5 and 6 is used. In other words, in the partial image generation method illustrated in FIGS. 11 to 14, the center of the viewing field has a smaller weighting than in the partial image generation method illustrated in FIGS. 5 and 6.

By selecting the partial image generation method in accordance with the state of the surface of the specimen S in this manner, the height of the specimen can be adjusted more accurately and more quickly. Therefore, the control section 80 may, for example, receive information indicating a partial image generation method selected by the user via the input device, and execute the processing for generating the partial images using the selected generation method.

Note that when the flat surface S1 illustrated in FIG. 16 is comparatively small, an observation magnification may be modified so that the majority of the viewing field of the SEM image is on the flat surface S1.

4.2. Second Modified Example

In the above embodiments, the control section 80 executes processing (step S101 and step S104 in FIGS. 8 to 10) to adjust the contrast and brightness when capturing the SEM images, but instead, the contrast and brightness may be adjusted by executing image processing on the captured SEM images $I_A$, $I_B$ so as to reduce contrast/brightness differences caused by the difference in the tilt angle.

4.3. Third Modified Example

Furthermore, in the above embodiments, the magnification at which the SEM image $I_A$ and the SEM image $I_B$ are captured for the n + 1$^{th}$ time is set to be larger than the magnification at which the SEM image $I_A$ and the SEM image $I_B$

$I_B$ are captured for the $n^{th}$ time (see step S111 in FIGS. 8 to 10), but instead, the magnification at which the SEM image $I_A$ and the SEM image $I_B$ are captured for the $n + 1^{th}$ time may be set to be identical to the magnification at which the SEM image $I_A$ and the SEM image $I_B$ are captured for the $n^{th}$ time.

In the above embodiments, the difference ($|T_0 - T_1|$) between the tilt angle $T_0$ and the tilt angle $T_1$ at which the SEM image $I_A$ and the SEM image $I_B$ are captured for the $n + 1^{th}$ time is set to be larger than the difference ($|T_0 - T_1|$) between the tilt angle $T_0$ and the tilt angle $T_1$ at which the SEM image $I_A$ and the SEM image $I_B$ are captured for the $n^{th}$ time (see step S112 in FIGS. 8 to 10), but instead, the difference ($|T_0 - T_1|$) between the tilt angle $T_0$ and the tilt angle $T_1$ at which the SEM image $I_A$ and the SEM image $I_B$ are captured for the $n + 1^{th}$ time may be set to be identical to the difference ($|T_0 - T_1|$) between the tilt angle $T_0$ and the tilt angle $T_1$ at which the SEM image $I_A$ and the SEM image $I_B$ are captured for the $n^{th}$ time.

### 4.4. Fourth Modified Example

In the above embodiments, a case in which the surface analysis device 100 is an Auger electron microscope was described, but the surface analysis device according to the invention is not limited thereto, and any surface analysis device having a specimen stage that includes a height direction moving mechanism for moving a specimen in a height direction and a tilting mechanism for tilting the specimen may be used. Examples of such surface analysis devices include a scanning electron microscope, an X-ray photoelectron spectroscope, an electron probe microanalyzer, and so on.

It should be noted that the embodiments and the modifications described above are merely examples and the invention is not limited thereto. For example, the respective embodiments and the respective modifications may be combined as appropriate.

The invention includes various other configurations which are substantially the same as the configurations described in the embodiments (for example, configurations having the same functions and methods). In addition, the invention includes various other configurations obtained by replacing nonessential portions of the configurations described in the embodiments. Moreover, the invention includes various other configurations obtained by adding known art to the configurations described in the embodiments.

While some embodiments of the invention have been described in detail above, a person skilled in the art will readily appreciate that various modifications can be made without materially departing from the novel teachings and effects of the invention. Accordingly, all such modifications are assumed to be included in the scope of the invention.

## Claims

1.  A surface analysis device (100) including a specimen stage (50) having a height direction moving mechanism for moving a specimen (S) in a direction of an optical axis of the surface analysis device and a tilting mechanism for tilting the specimen about a tilt axis,
    the surface analysis device comprising a control section (80) for controlling the specimen stage (50),
    the control section (80) being configured to execute:

    specimen image acquisition processing for obtaining a first specimen image captured with a first tilt angle of the specimen (S) and a second specimen image captured with a second tilt angle of the specimen (S) which is different from the first tilt angle;
    deviation amount calculation processing for calculating an amount of deviation of a specimen surface ($\Delta Z$) from a reference height defined by the intersection between the tilt axis and the optical axis based on the first specimen image and the second specimen image; and
    height control processing for controlling the specimen stage (50) based on the amount of deviation of the specimen surface ($\Delta Z$) to align the height of the specimen surface at said intersection between the tilt axis and the optical axis,

    **characterized in that**:

    the control section (80) is further configured to execute, in the deviation amount calculation processing,
    generating a plurality of first partial images by cutting out a plurality of areas from the first specimen image,
    generating a plurality of second partial images by cutting out a plurality of areas corresponding to the plurality of areas cut out from the first specimen image, from the second specimen image,
    enlarging the plurality of first and second partial images to make them the same size as the first specimen image and the second specimen image, respectively,

calculating respective amounts of deviation of the cut-out areas from the reference height by measuring respective shift amounts between corresponding images of the first partial images and the second partial images determining a median value from the amounts of deviation of the cut-out areas from the reference height, calculated from the respective areas, and

setting the median value as the amount of deviation of the specimen surface.

2. The surface analysis device (100) according to claim 1,
wherein the control section (50) is further configured to execute determination processing for determining whether or not a number of repetitions of the specimen image acquisition processing, the deviation amount calculation processing, and the height control processing has reached a target number; and
wherein, in a case where determination is made that the target number has not been reached, the control section executes the specimen image acquisition processing, the deviation amount calculation processing, and the height control processing again.

3. The surface analysis device (100) according to claim 1,
wherein the control section (50) is further configured, after executing the deviation amount calculation processing, to execute determination processing for determining whether or not an absolute value of the amount of deviation of the specimen surface, calculated in the deviation amount calculation processing, is equal to or smaller than a predetermined value; and
wherein, in a case where determination is made that the absolute value of the amount of deviation of the specimen surface is not equal to or smaller than the predetermined value, the control section executes the height control processing, and then executes the specimen image acquisition processing and the deviation amount calculation processing again.

4. The surface analysis device (100) according to claim 2 or 3,
wherein the control section (50) is further configured to set a difference between the first tilt angle and the second tilt angle when the first specimen image and the second specimen image are captured for an $n + 1^{th}$ time to be greater than the difference when the first specimen image and the second specimen image are captured for an $n^{th}$ time.

5. The surface analysis device (100) according to any one of claims 2 to 4,
wherein the control section (50) is further configured to set a magnification at which the first specimen image and the second specimen image are captured for an $n + 1^{th}$ time to be greater than the magnification at which the first specimen image and the second specimen image are captured for an $n^{th}$ time.

6. The surface analysis device (100) according to any one of claims 1 to 5,
wherein the control section (50) is further configured, during the deviation amount calculation processing, to:

generate the plurality of first partial images by cutting out a plurality of areas having mutually different sizes and a common center of a viewing field which is the center of the first specimen image, from the first specimen image, and
generate the plurality of second partial images by cutting out a plurality of areas having mutually different sizes and a common center of a viewing field which is the center of the second specimen image, from the second specimen image.

7. The surface analysis device (100) according to any one of claims 1 to 5,
wherein the control section (50) is further configured, during the deviation amount calculation processing, to:

generate the plurality of first partial images by cutting out a plurality of areas of a first size and having mutually different viewing field centers, from the first specimen image, and then cutting out a plurality of areas of a second size which is different from the first size and having mutually different viewing field centers, from the first specimen image, and
generate the plurality of second partial images by cutting out a plurality of areas of the first size and having mutually different viewing field centers, from the second specimen image, and then cutting out a plurality of areas of the second size and having mutually different viewing field centers, from the second specimen image.

8. The surface analysis device (100) according to any of claims 1 to 7, wherein the control section (50) is further configured to execute determination processing for determining whether or not the determined amount of deviation of the specimen surface is probable after the deviation amount calculation processing and before the height control processing, and

wherein, in the determination processing for determining whether or not the amount of deviation of the specimen surface is probable, the determined amount of deviation of the specimen surface is determined to be probable when the median value has been set as the amount of deviation of the specimen surface and at least a predetermined number of the amounts of deviation calculated from the other areas exist within a set error range of the amount of deviation of the specimen surface.

9. A specimen height adjustment method executed by a surface analysis device including a specimen stage that has a height direction moving mechanism for moving a specimen in a direction of an optical axis of the surface analysis device and a tilting mechanism for tilting the specimen about a tilt axis,
the method comprising:

obtaining a first specimen image captured with a first tilt angle of the specimen and a second specimen image captured with a second tilt angle of the specimen, which is different from the first tilt angle;
calculating an amount of deviation of a specimen surface from a reference height defined by the intersection between the tilt axis and the optical axis based on the first specimen image and the second specimen image; and
adjusting the height of the specimen based on the amount of deviation of the specimen surface to align the height of the specimen surface at said intersection between the tilt axis and the optical axis,

**characterized in that**:

in calculating the amount of deviation of the specimen surface,
a plurality of first partial images being generated by cutting out a plurality of areas from the first specimen image,
a plurality of second partial images being generated by cutting out a plurality of areas corresponding to the plurality of areas cut out from the first specimen image, from the second specimen image,
enlarging the plurality of first and second partial images to make them the same size as the first specimen image and the second specimen image, respectively,
calculating the respective amounts of deviation of the cut-out areas from the reference height by measuring respective shift amounts between corresponding images of the first partial images and the second partial images,
determining a median value from the amounts of deviation of the cut-out areas from the reference height, calculated from the respective areas, and
setting the median value as the amount of deviation of the specimen surface.

## Patentansprüche

1. Oberflächenanalysevorrichtung (100), die einen Probentisch (50) mit einem Höhenrichtungsbewegungsmechanismus zum Bewegen einer Probe (S) in Richtung einer optischen Achse der Oberflächenanalysevorrichtung und einem Kippmechanismus zum Kippen der Probe um eine Kippachse einschließt,
wobei die Oberflächenanalysevorrichtung einen Kontrollabschnitt (80) zur Kontrolle des Probentisches (50) umfasst, der Kontrollabschnitt (80) zur Ausführung von Folgendem konfiguriert wird:

Probenbildaufnahmeverarbeitung zum Erhalten eines ersten Probenbildes, das mit einem ersten Neigungswinkel der Probe (S) aufgenommen wurde, und eines zweiten Probenbildes, das mit einem zweiten Neigungswinkel der Probe (S) aufgenommen wurde, der sich von dem ersten Neigungswinkel unterscheidet;
Abweichungsbetragsberechnungsverarbeitung zum Berechnen eines Abweichungsbetrags einer Probenoberfläche (AZ) von einer Referenzhöhe, die durch den Schnittpunkt zwischen der Kippachse und der optischen Achse definiert ist, basierend auf dem ersten Probenbild und dem zweiten Probenbild; und
Höhenkontrollverarbeitung zur Kontrolle des Probentisches (50) auf der Grundlage des Ausmaßes der Abweichung der Probenoberfläche (AZ), um die Höhe der Probenoberfläche an dem genannten Schnittpunkt zwischen der Kippachse und der optischen Achse auszurichten,
**dadurch gekennzeichnet, dass**:

der Kontrollabschnitt (80) ferner zur Ausführung, in der Abweichungsbetragsberechnungsverarbeitung, von folgendem konfiguriert ist,
Erzeugen einer Vielzahl von ersten Teilbildern durch Ausschneiden einer Vielzahl von Bereichen aus dem ersten Probenbild,

Erzeugen einer Vielzahl von zweiten Teilbildern durch Ausschneiden einer Vielzahl von Bereichen, die der Vielzahl der aus dem ersten Probenbild ausgeschnittenen Bereiche entsprechen, aus dem zweiten Probenbild,

Vergrößern der Vielzahl von ersten und zweiten Teilbilder, um sie auf die gleiche Größe wie das erste bzw. zweite Probenbild zu bringen,

Berechnen jeweiliger von Abweichungsbeträge der ausgeschnittenen Bereiche von der Referenzhöhe durch Messen jeweiliger Verschiebungsbeträge zwischen entsprechenden Bildern der ersten Teilbilder und der zweiten Teilbilder, Bestimmen eines Medianwertes aus den aus den jeweiligen Bereichen berechneten Abweichungsbeträgen der ausgeschnittenen Bereiche von der Referenzhöhe, und Einstellen des Medianwertes als der Abweichungsbetrag der Probenoberfläche.

2. Oberflächenanalysevorrichtung (100) nach Anspruch 1,
wobei der Kontrollabschnitt (50) ferner konfiguriert ist, um eine Bestimmungsverarbeitung auszuführen, um zu bestimmen, ob eine Anzahl von Wiederholungen der Probenbildaufnahmeverarbeitung, der Abweichungsbetragsberechnungsverarbeitung und der Höhenkontrollverarbeitung eine Zielanzahl erreicht hat oder nicht; und
wobei in einem Fall, in dem festgestellt wird, dass die Zielanzahl nicht erreicht wurde, der Kontrollabschnitt die Probenbildaufnahmeverarbeitung, die Abweichungsbetragsberechnungsverarbeitung und die Höhenkontrollverarbeitung erneut ausführt.

3. Oberflächenanalysevorrichtung (100) nach Anspruch 1,
wobei der Kontrollabschnitt (50) ferner so konfiguriert ist, nach Ausführung der Abweichungsbetragsberechnungsverarbeitung, eine Bestimmungsverarbeitung auszuführen, um zu bestimmen, ob ein Absolutwert des Abweichungsbetrags der Probenoberfläche, der in der Abweichungsbetragsberechnungsverarbeitung berechnet wurde, gleich oder kleiner als ein vorbestimmter Wert ist oder nicht; und wobei in einem Fall, in dem bestimmt wird, dass der Absolutwert des Abweichungsbetrags der Probenoberfläche nicht gleich oder kleiner ist als der vorbestimmte Wert, der Kontrollabschnitt die Höhenkontrollverarbeitung ausführt, und dann die Probenbildaufnahmeverarbeitung und die Abweichungsbetragsberechnungsverarbeitung erneut ausführt.

4. Oberflächenanalysevorrichtung (100) nach Anspruch 2 oder 3,
wobei der Kontrollabschnitt (50) ferner konfiguriert ist, um eine Differenz zwischen dem ersten Neigungswinkel und dem zweiten Neigungswinkel, wenn das erste Probenbild und das zweite Probenbild ein n+1-tes Mal aufgenommen werden, einzustellen, um größer zu sein als die Differenz, wenn das erste Probenbild und das zweite Probenbild ein n-tes Mal aufgenommen werden.

5. Oberflächenanalysevorrichtung (100) nach einem der Ansprüche 2 bis 4,
wobei der Kontrollabschnitt (50) ferner konfiguriert ist, um eine Vergrößerung, bei der das erste Probenbild und das zweite Probenbild eine n+1-te zeitlang aufgenommen werden, einzustellen, um größer zu sein als die Vergrößerung, bei der das erste Probenbild und das zweite Probenbild eine n-te zeitlang aufgenommen werden.

6. Oberflächenanalysevorrichtung (100) nach einem der Ansprüche 1 bis 5,
wobei der Kontrollabschnitt (50) ferner während der Abweichungsbetragsberechnungsverarbeitung konfiguriert ist, um:
die Vielzahl von ersten Teilbildern durch Ausschneiden einer Vielzahl von Bereichen mit voneinander unterschiedlichen Größen und einem gemeinsamen Zentrum eines Sichtfeldes, das das Zentrum des ersten Probenbildes ist, aus dem ersten Probenbild zu erzeugen, und die Vielzahl von zweiten Teilbildern durch Ausschneiden einer Vielzahl von Bereichen mit voneinander unterschiedlichen Größen und einem gemeinsamen Zentrum eines Sichtfeldes, das das Zentrum des zweiten Probenbildes ist, aus dem zweiten Probenbild zu erzeugen.

7. Oberflächenanalysevorrichtung (100) nach einem der Ansprüche 1 bis 5, wobei der Kontrollabschnitt (50) ferner konfiguriert ist, während der Abweichungsbetragsberechnungsverarbeitung:
die Vielzahl von ersten Teilbildern durch Ausschneiden einer Vielzahl von Bereichen mit einer ersten Größe und mit voneinander unterschiedlichen Sichtfeldzentren aus dem ersten Probenbild zu erzeugen, und dann eine Vielzahl von Bereichen einer zweiten Größe, die sich von der ersten Größe unterscheidet und mit voneinander unterschiedlichen Sichtfeldzentren aus dem ersten Probenbild auszuschneiden, und die Vielzahl von zweiten Teilbildern durch Ausschneiden einer Vielzahl von Bereichen der ersten Größe und mit voneinander unterschiedlichen Sichtfeldzentren aus dem zweiten Probenbild zu erzeugen, und dann eine Vielzahl von Bereichen der zweiten Größe und mit voneinander unterschiedlichen Sichtfeldzentren aus dem zweiten Probenbild auszuschneiden.

8. Oberflächenanalysevorrichtung (100) nach einem der Ansprüche 1 bis 7,
wobei der Kontrollabschnitt (50) ferner konfiguriert ist, um eine Bestimmungsverarbeitung auszuführen, um zu bestimmen, ob der bestimmte Abweichungsbetrag der Probenoberfläche nach der Abweichungsbetragsberechnungsverarbeitung und vor der Höhenkontrollverarbeitung wahrscheinlich ist oder nicht, und
wobei bei der Bestimmungsverarbeitung zur Bestimmung, ob der Betrag der Abweichung der Probenoberfläche wahrscheinlich ist oder nicht, der bestimmte Abweichungsbetrag der Probenoberfläche als wahrscheinlich bestimmt wird, wenn der Medianwert als der Abweichungsbetrag der Probenoberfläche eingestellt wurde und mindestens eine vorbestimmte Anzahl der aus den anderen Bereichen berechneten Abweichungsbeträge innerhalb eines eingestellten Fehlerbereichs des Abweichungsbetrags der Probenoberfläche vorhanden ist.

9. Probenhöheneinstellungsverfahren, das von einer Oberflächenanalysevorrichtung ausgeführt wird, die einen Probentisch einschließt, der einen Höhenrichtungsbewegungsmechanismus, zum Bewegen einer Probe in Richtung einer optischen Achse der Oberflächenanalysevorrichtung und einen Kippmechanismus zum Kippen der Probe um eine Kippachse aufweist,
wobei das Verfahren Folgendes umfasst:

Erhalten eines ersten Probenbildes, das mit einem ersten Neigungswinkel der Probe aufgenommen wurde, und eines zweiten Probenbildes, das mit einem zweiten Neigungswinkel der Probe, der sich von dem ersten Neigungswinkel unterscheidet, aufgenommen wurde;
Berechnen eines Abweichungsbetrags einer Probenoberfläche von einer Referenzhöhe, die durch den Schnittpunkt zwischen der Kippachse und der optischen Achse definiert ist, auf der Grundlage des ersten Probenbildes und des zweiten Probenbildes; und
Einstellung der Höhe der Probe auf der Grundlage des Abweichungsbetrags der Probenoberfläche, um die Höhe der Probenoberfläche an dem Schnittpunkt zwischen der Kippachse und der optischen Achse auszurichten, **dadurch gekennzeichnet, dass**
bei der Berechnung des Abweichungsbetrags der Probenoberfläche,
eine Vielzahl von ersten Teilbildern durch Ausschneiden einer Vielzahl von Bereichen aus dem ersten Probenbild erzeugt wird,
eine Vielzahl von zweiten Teilbildern durch Ausschneiden einer Vielzahl von Bereichen, die der Vielzahl der aus dem ersten Probenbild ausgeschnittenen Bereiche entspricht, aus dem zweiten Probenbild erzeugt wird,
die Vielzahl von ersten und zweiten Teilbildern vergrößert wird, um die Größe gleich dem ersten bzw. zweiten Probenbild zu machen,
die jeweiligen Abweichungsbeträge der Ausschnittbereiche von der Referenzhöhe durch Messen der jeweiligen Verschiebungsbeträge zwischen entsprechenden Bildern der ersten Teilbilder und der zweiten Teilbilder berechnet werden,
ein Medianwert aus den aus den jeweiligen Bereichen berechneten Abweichungsbeträgen der Ausschnittflächen von der Referenzhöhe bestimmt und der Medianwert als Abweichungsbetrag der Probenoberfläche eingestellt wird.

**Revendications**

1. Dispositif d'analyse de surface (100) incluant une platine porte-échantillon (50) présentant un mécanisme de déplacement dans la direction de la hauteur pour déplacer un échantillon (S) dans une direction d'un axe optique du dispositif d'analyse de surface et un mécanisme d'inclinaison destiné à incliner l'échantillon autour d'un axe d'inclinaison ;
le dispositif d'analyse de surface comprenant une section de commande (80) destinée à commander la platine porte-échantillon (50) ;
la section de commande (80) étant configurée de manière à exécuter :

un traitement d'acquisition d'images d'échantillon consistant à obtenir une première image d'échantillon capturée avec un premier angle d'inclinaison de l'échantillon (S) et une seconde image d'échantillon capturée avec un second angle d'inclinaison de l'échantillon (S) qui est différent du premier angle d'inclinaison ;
un traitement de calcul de quantité d'écart consistant à calculer une quantité d'écart d'une surface d'échantillon ($\Delta Z$) par rapport à une hauteur de référence définie par l'intersection entre l'axe d'inclinaison et l'axe optique sur la base de la première image d'échantillon et de la seconde image d'échantillon ; et
un traitement de commande de hauteur consistant à commander la platine porte-échantillon (50) sur la base de la quantité d'écart de la surface d'échantillon ($\Delta Z$) en vue d'aligner la hauteur de la surface d'échantillon, à ladite intersection entre l'axe d'inclinaison et l'axe optique ;

**caractérisé en ce que** :
la section de commande (80) est en outre configurée de manière à exécuter, dans le cadre du traitement de calcul de quantité d'écart, les étapes ci-dessous consistant à :

générer une pluralité de premières images partielles, en découpant une pluralité de zones à partir de la première image d'échantillon ;
générer une pluralité de secondes images partielles, en découpant une pluralité de zones correspondant à la pluralité de zones découpée à partir de la première image d'échantillon, à partir de la seconde image d'échantillon ;
agrandir la pluralité de premières et secondes images partielles jusqu'à la même taille que les première et seconde images d'échantillon, respectivement ;
calculer des quantités d'écart respectives des zones découpées par rapport à la hauteur de référence, en mesurant des quantités de décalage respectives entre des images correspondantes des premières images partielles et des secondes images partielles ;
déterminer une valeur médiane à partir des quantités d'écart des zones découpées par rapport à la hauteur de référence, calculées à partir des zones respectives ; et
définir la valeur médiane en tant que la quantité d'écart de la surface d'échantillon.

2. Dispositif d'analyse de surface (100) selon la revendication 1,
dans lequel la section de commande (50) est en outre configurée de manière à exécuter un traitement de détermination consistant à déterminer si un nombre de répétitions du traitement d'acquisition d'images d'échantillon, du traitement de calcul de quantité d'écart et du traitement de commande de hauteur a atteint ou non un nombre cible ; et
dans lequel, dans le cas où il est déterminé que le nombre cible n'a pas été atteint, la section de commande exécute à nouveau le traitement d'acquisition d'images d'échantillon, le traitement de calcul de quantité d'écart et le traitement de commande de hauteur.

3. Dispositif d'analyse de surface (100) selon la revendication 1,
dans lequel la section de commande (50) est en outre configurée, après avoir exécuté le traitement de calcul de quantité d'écart, de manière à exécuter un traitement de détermination consistant à déterminer si une valeur absolue de la quantité d'écart de la surface d'échantillon, calculée dans le cadre du traitement de calcul de quantité d'écart, est ou non égale ou inférieure à une valeur prédéterminée ; et
dans lequel, dans le cas où il est déterminé que la valeur absolue de la quantité d'écart de la surface d'échantillon n'est pas égale ou inférieure à la valeur prédéterminée, la section de commande exécute le traitement de commande de hauteur, et exécute ensuite à nouveau le traitement d'acquisition d'images d'échantillon et le traitement de calcul de quantité d'écart.

4. Dispositif d'analyse de surface (100) selon la revendication 2 ou 3,
dans lequel la section de commande (50) est en outre configurée de manière à définir une différence entre le premier angle d'inclinaison et le second angle d'inclinaison lorsque la première image d'échantillon et la seconde image d'échantillon sont capturées pour une $n + 1^{\text{ième}}$ fois, afin qu'elle soit supérieure à la différence lorsque la première image d'échantillon et la seconde image d'échantillon sont capturées pour une $n^{\text{ième}}$ fois.

5. Dispositif d'analyse de surface (100) selon l'une quelconque des revendications 2 à 4,
dans lequel la section de commande (50) est en outre configurée de manière à définir un grossissement auquel la première image d'échantillon et la seconde image d'échantillon sont capturées pour une $n + 1^{\text{ième}}$ fois, afin qu'il soit supérieur au grossissement auquel la première image d'échantillon et la seconde image d'échantillon sont capturées pour une $n^{\text{ième}}$ fois.

6. Dispositif d'analyse de surface (100) selon l'une quelconque des revendications 1 à 5,
dans lequel la section de commande (50) est en outre configurée, au cours du traitement de calcul de quantité d'écart, de manière à :

générer la pluralité de premières images partielles en découpant une pluralité de zones présentant des tailles mutuellement différentes et un centre commun d'un champ de vision qui est le centre de la première image d'échantillon, à partir de la première image d'échantillon ; et
générer la pluralité de secondes images partielles en découpant une pluralité de zones présentant des tailles mutuellement différentes et un centre commun d'un champ de vision qui est le centre de la seconde image d'échantillon, à partir de la seconde image d'échantillon.

7. Dispositif d'analyse de surface (100) selon l'une quelconque des revendications 1 à 5, dans lequel la section de commande (50) est en outre configurée, au cours du traitement de calcul de quantité d'écart, de manière à :

générer la pluralité de premières images partielles en découpant une pluralité de zones d'une première taille, et présentant des centres de champ de vision mutuellement différents, à partir de la première image d'échantillon, et en découpant ensuite une pluralité de zones d'une seconde taille qui est différente de la première taille, et présentant des centres de champ de vision mutuellement différents, à partir de la première image d'échantillon ; et

générer la pluralité de secondes images partielles en découpant une pluralité de zones de la première taille, et présentant des centres de champ de vision mutuellement différents, à partir de la seconde image d'échantillon, et en découpant ensuite une pluralité de zones de la seconde taille, et présentant des centres de champ de vision mutuellement différents, à partir de la seconde image d'échantillon.

8. Dispositif d'analyse de surface (100) selon l'une quelconque des revendications 1 à 7, dans lequel la section de commande (50) est en outre configurée de manière à exécuter un traitement de détermination pour déterminer si la quantité d'écart déterminée de la surface d'échantillon est probable ou non, après le traitement de calcul de quantité d'écart et avant le traitement de commande de hauteur ; et dans lequel, dans le cadre du traitement de détermination pour déterminer si la quantité d'écart de la surface d'échantillon est probable ou non, la quantité d'écart déterminée de la surface d'échantillon est déterminée comme étant probable lorsque la valeur médiane a été définie en tant que la quantité d'écart de la surface d'échantillon, et lorsqu'au moins un nombre prédéterminé de quantités d'écart calculées à partir des autres zones existe dans une plage d'erreur définie de la quantité d'écart de la surface d'échantillon.

9. Procédé d'ajustement de hauteur d'échantillon exécuté par un dispositif d'analyse de surface comprenant une platine porte-échantillon qui présente un mécanisme de déplacement dans la direction de la hauteur pour déplacer un échantillon dans une direction d'un axe optique du dispositif d'analyse de surface, et un mécanisme d'inclinaison destiné à incliner l'échantillon autour d'un axe d'inclinaison ; le procédé comprenant les étapes ci-dessous consistant à :

obtenir une première image d'échantillon capturée avec un premier angle d'inclinaison de l'échantillon et une seconde image d'échantillon capturée avec un second angle d'inclinaison de l'échantillon, qui est différent du premier angle d'inclinaison ;

calculer une quantité d'écart d'une surface d'échantillon par rapport à une hauteur de référence définie par l'intersection entre l'axe d'inclinaison et l'axe optique sur la base de la première image d'échantillon et de la seconde image d'échantillon ; et

ajuster la hauteur de l'échantillon sur la base de la quantité d'écart de la surface d'échantillon en vue d'aligner la hauteur de la surface d'échantillon, à ladite intersection entre l'axe d'inclinaison et l'axe optique ;

**caractérisé en ce que** :
dans le cadre du calcul de la quantité d'écart de la surface d'échantillon :

une pluralité de premières images partielles est générée, en découpant une pluralité de zones à partir de la première image d'échantillon ;

une pluralité de secondes images partielles est générée, en découpant une pluralité de zones correspondant à la pluralité de zones découpée à partir de la première image d'échantillon, à partir de la seconde image d'échantillon ; et

agrandir la pluralité de premières et secondes images partielles jusqu'à la même taille que la première image d'échantillon et la seconde image d'échantillon, respectivement ;

calculer les quantités d'écart respectives des zones découpées par rapport à la hauteur de référence, en mesurant des quantités de décalage respectives entre des images correspondantes des premières images partielles et des secondes images partielles ;

déterminer une valeur médiane à partir des quantités d'écart des zones découpées par rapport à la hauteur de référence, calculées à partir des zones respectives ; et

définir la valeur médiane en tant que la quantité d'écart de la surface d'échantillon.

FIG. 1

EP 3 432 339 B1

FIG. 2

FIG. 3

FIG. 4

FIG. 5

FIG. 6

```
                    ┌──────────────────┐
                    │      START       │
                    └──────────────────┘
                             │
                             ▼      ╱S10
                      ╱─────────────╲
                     ╱     START      ╲         No
                    ╱   INSTRUCTION     ╲───────────┐
                     ╲    ISSUED?      ╱            │
                      ╲───────────────╱             │
                             │ Yes    ╱S11          │
                    ┌──────────────────┐            │
                    │ STORE STATE OF DEVICE │        │
                    └──────────────────┘            │
                             │         ╱S12          │
                    ┌──────────────────┐            │
                    │ PREPARE FOR IMAGE CAPTURE │    │
                    └──────────────────┘            │
                             │           ╱S13        │
                      ╱─────────────────╲            │
                     ╱                    ╲    No     │
                    ╱  CAN FOCUS BE INITIALIZED? ╲────┐
                     ╲                    ╱           │
                      ╲─────────────────╱            │
                             │ Yes    ╱S14           │
                    ┌──────────────────┐             │
                    │  INITIALIZE FOCUS  │            │
                    └──────────────────┘◄────────────┘
                             │         ╱S15
                    ┌──────────────────┐
                    │ ADJUST HEIGHT OF SPECIMEN │
                    └──────────────────┘
                             │         ╱S16
                    ┌──────────────────┐
                    │ RETURN TO ORIGINAL DEVICE STATE │
                    └──────────────────┘
                             │
                             ▼
                    ┌──────────────────┐
                    │       END        │
                    └──────────────────┘
```

# FIG. 7

START HEIGHT
ADJUSTMENT

S100
TILT SPECIMEN ($T_0$)

S101
ADJUST CONTRAST/BRIGHTNESS

S102
CAPTURE SEM IMAGE $I_A$

S103
TILT SPECIMEN ($T_1$)

S104
ADJUST CONTRAST/BRIGHTNESS

S105
CAPTURE SEM IMAGE $I_B$

S106
GENERATE PARTIAL IMAGES

S107
CALCULATE AMOUNT
OF DEVIATION $\Delta Z$

S108
MOVEMENT
POSSIBLE? — No

Yes S109
CONTROL SPECIMEN STAGE

S110
n=N?

No — n=n+1

S111
MODIFY
MAGNIFICATION

S112
MODIFY
TILT ANGLE

Yes
TERMINATE HEIGHT
ADJUSTMENT

FIG. 8

28

START HEIGHT ADJUSTMENT

S100 TILT SPECIMEN ($T_0$)

S101 ADJUST CONTRAST/BRIGHTNESS

S102 CAPTURE SEM IMAGE $I_A$

S103 TILT SPECIMEN ($T_1$)

S104 ADJUST CONTRAST/BRIGHTNESS

S105 CAPTURE SEM IMAGE $I_B$

S106 GENERATE PARTIAL IMAGES

S107 CALCULATE AMOUNT OF DEVIATION $\Delta Z$

S200 IS $\Delta Z$ PROBABLE? — No

Yes

S108 MOVEMENT POSSIBLE? — No

Yes

S109 CONTROL SPECIMEN STAGE

S110 n=N? — No

n=n+1

S111 MODIFY MAGNIFICATION

S112 MODIFY TILT ANGLE

Yes

TERMINATE HEIGHT ADJUSTMENT

FIG. 9

START HEIGHT
ADJUSTMENT

TILT SPECIMEN ($T_0$) — S100

ADJUST CONTRAST/BRIGHTNESS — S101

CAPTURE SEM IMAGE $I_A$ — S102

TILT SPECIMEN ($T_1$) — S103

ADJUST CONTRAST/BRIGHTNESS — S104

CAPTURE SEM IMAGE $I_B$ — S105

GENERATE PARTIAL IMAGES — S106

CALCULATE AMOUNT OF
DEVIATION $\Delta Z$ — S107

$|\Delta Z| \leq z$ ? — S300 — Yes

No

MOVEMENT
POSSIBLE? — S108 — No

Yes

CONTROL SPECIMEN STAGE — S109

MODIFY MAGNIFICATION — S111

MODIFY TILT ANGLE — S112

TERMINATE HEIGHT
ADJUSTMENT

FIG. 10

30

FIG. 11

FIG. 12

FIG. 13

FIG. 14

FIG. 15

FIG. 16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP H10269979 A